# EUROPEAN PATENT SPECIFICATION

(11) **EP 2 416 368 B1**
(45) Date of publication and mention of the grant of the patent: **24.10.2018**
(21) Application number: 10758681.0
(22) Date of filing: 30.03.2010
(51) Int. Cl.: H01L 31/02, G02B 6/42

(54) **OPTICAL COMMUNICATION MODULE AND MANUFACTURING METHOD THEREFOR**
OPTISCHES KOMMUNIKATIONSMODUL UND VERFAHREN ZU SEINER HERSTELLUNG
MODULE DE COMMUNICATION OPTIQUE ET PROCÉDÉ DE FABRICATION DE CELUI-CI

(30) Priority: 30.03.2009 JP 2009082465; 30.03.2009 JP 2009082467; 03.11.2009 JP 2009252528; 02.12.2009 JP 2009274680
(43) Date of publication of application: 08.02.2012
(73) Proprietor: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Chuo-ku Osaka-shi Osaka 541-0041 (JP)
(72) Inventor: HAYASHI, Shigeo, Yokkaichi-shi Mie 510-8503 (JP)
(74) Representative: Winter, Brandl, Fürniss, Hübner, Röss, Kaiser, Polte - Partnerschaft mbB
(86) International application number: PCT/JP2010/055628
(87) International publication number: WO 2010/113910

(56) References cited:
- WO-A1-01/01497
- JP-A- 10 056 209
- JP-A- 55 024 404
- JP-A- 2002 267 893
- JP-A- 2002 267 893
- JP-A- 2005 057 310
- JP-A- 2005 057 310
- JP-A- 2005 268 737
- JP-A- 2005 340 770
- JP-A- 2006 202 998
- US-A1- 2004 227 145
- US-A1- 2005 254 758

## Description

### BACKGROUND OF THE INVENTION

### 1. Field of the Invention

The present invention relates to an optical communication module that packages a photoelectric conversion device, such as a laser diode and/or photodiode utilized for performing an optical communication, and relates to a method for manufacturing the optical communication module.

### 2. Description of Related Art

Conventionally, the optical communication has become widespread, which utilizes an optical fiber and the like. The optical communication is performed with a photoelectric conversion device, such as a laser diode, converting an electrical signal into an optical signal. The converted optical signal is transmitted through an optical fiber. Then, another photoelectric conversion device, such as a photodiode, converts the received optical signal into the electrical signal. Thus, a well utilized optical communication module packages photoelectric conversion devices, such as a laser diode and/or photodiode, together with or without a peripheral circuit element for operating the photoelectric conversion devices. Such an optical communication module is called an optical sub-assembly (OSA). Recently, several inventions have been developed for the optical communication and optical communication module.

For example, Patent Document 1 proposes an optical detector applicable for communication requiring fast and wide dynamic range. In the proposed optical detector, each of the outputs of the first photodiode (optical receiver) and the second photodiode (optically shielded) are input into a differential amplifier via a gain adjustment amplifier. In addition, the proposed optical detector is configured with a lowpass filter arranged between an output terminal of an optical power detecting unit and a gain adjustment terminal of the gain adjustment amplifier.

In addition, Patent Document 2 proposes an optical receiver that can control amounts of operating current and voltage, as appropriate, and can reduce the electric power consumption. In the proposed optical receiver, a photodiode for receiving signals, photodiode for detecting optical levels, signal amplifier amplifying received signals and bias current control unit controlling bias current supplied to the signal amplifier are arranged on the same board, and the bias current control unit actuates the signal amplifier when the signal current output from the photodiode for detecting optical levels becomes more than a predetermined reference value. Furthermore, the photodiode for receiving signals has a substantially-oval photoresponse region smaller than the diffusion of optical signal, while the photodiode for detecting optical levels has a photoresponse region that is surrounding the photoresponse region of the photodiode for receiving signals. Thus, this optical receiver can effectively detect optical signals and can improve the reception ability.

The Patent Documents 1 and 2 described above relate to a peripheral circuit of the photoelectric conversion device, and try to improve the peripheral circuit for enhancing the ability of optical communication. In the Patent Documents 1 and 2, the photoelectric conversion device and peripheral circuit are arranged on a circuit board that is fixed to a lead frame and is sealed with transparent resin to form a molded unit, and a hemisphere lens unit is put on the surface of molded unit to form an optical communication module. In the optical communication module, the lens unit is arranged to be opposed to the output terminal of optical fiber.

In addition, Patent Document 3 proposes an optic-electric conversion module that has an excellent high frequency characteristic and whose size can be reduced. The optic-electric conversion module includes a photoelectric conversion device sending or receiving optical signals, a stem for fixing the photoelectric conversion device, a cap for covering the photoelectric conversion device and plural leads that apply electrical signals to the photoelectric conversion device and that send electrical signals transmitted from the photoelectric conversion device. A flat surface is prepared on one end portion of a predetermined lead located in a package formed with the stem and cap. On the flat surface, an electrical circuit component is arranged, whose one end is connected to the photoelectric conversion device and the other end is connected to the lead. Thus, the optic-electric conversion module with an enhanced high-frequency characteristic that can be reduced in size is proposed.

Patent Document 4 proposes an optical device module including a circuit element arranged on a circuit board or the like that can actuate an optical source and/or optical detector. The optical device module contains an optical source and/or optical detector, and includes: a first package that has a first surface formed with an opening portion passing optical signals and has an opposing second surface; a second package that is formed with an opening portion containing an insertion material, such as a circuit board, and is arranged perpendicularly onto the second surface of the first packeage; and a lead frame that mechanically connects the first package to second package, and electrically connects the optical source and/or optical detector in the first package to a connection point exposed within the opening portion of second package. In the optical device module, the insertion material, such as a circuit board, is further mechanically connected to the second package and electrically connected to the connection point in the opening portion. Furthermore, a lens block holding the lens is fixed to the first package in this optical device module, and an optical fiber is fit to an opening portion formed on the lens block.

Patent Document 5 proposes a method of manufacturing a lead frame connector that is utilized for connecting an optic sub assembly to a printed circuit board (PCB) in an optical communication module. In this method, a shape of conductor is stamped on a conductive ribbon, the conductor is bent appropriately, an injection molding process with the open reel system is utilized to form a case insulating the conductor, and then, the conductive ribbon is cut to configure a single lead frame connector. It is possible to electrically isolate plural conductors contained in one case from each other, by punching the connecting portion through the hole formed on the case.

Patent Document 1: Japanese Patent Application Laid-Open No. 2006-40976
Patent Document 2: WO 01/015348
Patent Document 3: Japanese Patent Application Laid-Open No. 2005-167189
Patent Document 4 : US Patent No. 7,455,463
Patent Document 5: US Patent No. 7,370,414

### SUMMARY OF THE INVENTION

In a conventional optical communication module, a photoelectric conversion device (and peripheral circuit) is generally mounted on a lead frame, the photoelectric conversion device and lead frame are generally sealed with transparent resin, and further a lens is generally formed integrally using a resin material. If the precision for forming the resin part is low, the position of lens may not match with the position of photoelectric conversion device in such a conventional configuration described above. Thus, the performance of optical communication may be degraded. In addition, it is required to select a resin material in consideration of the heat resistance to be provided to the photoelectric conversion device, because the photoelectric conversion device is exposed to high temperature environments during the resin sealing. Thus, there is a limitation for resin materials to be selected. Therefore, it is difficult to solve the limitation because the resin material should be selected to form the resin part with high precision.

As utilized for performing the optical communication, an optical fiber is configured with a core that passes light and with a clad that surrounds the core and confines light. There are various types of optical fiber, based on the material of core and the material of clad: a hard polymer clad fiber (HPCF) in which the clad made of high-strength plastic surrounds the core made of silica glass, an all silica glass fiber (AGF) in which the core and clad are made of silica glass, and the like. The optical fiber is selected in consideration of communication speed, cost and the like. The HPCF is selected for the optical communication having a relatively slow speed, and the diameter of core is about 200 µm. The AGF is selected for the optical communication having a relatively high speed, and the diameter of core is about several micrometers to tens of micrometers. In contrast, the laser diode has a light emitting part whose size is about several micrometers to tens of micrometers, and the photodiode has a light receiving part whose size is about tens of micrometers. Therefore, it is required for the AGF including the core whose diameter is relatively small to perform the position adjustment to the light emitting part of laser diode or to the light receiving part of photodiode.

In Patent Documents 1 and 2, the photoelectric conversion device is sealed with resin to form a molded unit and the lens unit is arranged on the molded unit. Thus, the position of photoelectric conversion device may not match to the position of lens unit, if the precision for forming the lens unit with resin is low. Hence, the performance of optical communication may be reduced. In addition, the output terminal of optical fiber must be configured to be opposed to the lens unit in the arrangement of the optical communication module of Patent Documents 1 and 2. The position adjustment for the configuration is performed by inserting the optical fiber and communication module into a groove formed on another part. However, it is difficult to completely adjust and match the positions only by inserting the optical fiber and communication module into the groove formed on another part, and it is further required to perform further position adjustment for the optical fiber and lens unit, because there are problems about the precision for forming the molded unit of communication module and for forming said another part on which the groove is formed so that the communication module is inserted in the case that the optical fiber, such as the AGF, is selected for the optical communication with a relatively high speed.

The optic-electric conversion module of Patent Document 3 includes the photoelectric conversion device fixed to the stem and covered by the cap, instead of being sealed with resin. The lens is formed integrally with the cap. Therefore, it is required to precisely adjust and match the position of cap with the position of photoelectric conversion device. Furthermore, it is required to adjust and match the position of optic-electric conversion module with the position of optical fiber. If the precision for adjusting and matching the positions are low, the performance of optical communication with the optic-electric conversion module is reduced.

The photoelectric conversion device may be packaged together with another circuit component. For example, it is possible to package the photodiode and an amplifier circuit that amplifies voltage/current generated in response to the photodiode detecting light. Additionally, it is possible to package the laser diode and a driver circuit that generates voltage/current required for making the laser diode emit light. In the case utilizing the optical communication module packaged together with another circuit, the communication apparatus is not required to include such an additional circuit. Thus, it may be possible to reduce the size and cost of communication apparatus. However, such an optical communication module is desired to be small.

The optical device module of Patent Document 4 is formed with a complex configuration: the second package is arranged perpendicular onto the fist package containing the optical source and/or optical detector; the circuit board is arranged in the opening portion of second package; and the lens block is fixed to the first package. Thus, it is difficult to reduce the size of optical device module. Particularly, the size of circuit board and size of second package including the circuit board may be increased. In addition, it is difficult to reduce the cost of optical device module and to simplify the manufacturing processes of optical device module, because of the large number of component parts. The optical communication module utilizing the lead frame of Patent Document 5 is also configured similarly.

The present invention is made in view of such circumstances, and has an object to provide an optical communication module and method for manufacturing the optical communication module, which can prevent deterioration of communication performance caused by the improper positions of light emitting unit or light receiving unit in the photoelectric conversion device, lens, optical fibers and the like, and can enhance the accuracy of optical communication.

Another object of the present invention is to provide an optical communication module and method for manufacturing the optical communication module, which can prevent deterioration of communication performance caused by the improper positions of light emitting unit or light receiving unit in the photoelectric conversion device, lens, optical fibers and the like, which can reduce the number of required parts and which can reduce the size.

An optical communication module according to the present invention is defined by independent claim 1 and comprises: a photoelectric conversion device that is provided with a photoelectric conversion unit and a connector on one surface of the photoelectric conversion device, wherein the photoelectric conversion unit performs a photoelectric conversion from an optical signal to an electrical signal or from an electrical signal to an optical signal by receiving or emitting light, and the connector connects the photoelectric conversion device to another device; an electric conductor that is connected to the connector of the photoelectric conversion device and is provided with an optical pass portion that passes light toward the photoelectric conversion unit of the connected photoelectric conversion device; a transparency maintaining unit that comprises a transparent portion passing light between one side and the other side of the transparency maintaining unit and that holds the electric conductor, wherein a portion connecting the photoelectric conversion device is exposed at said one side; a sealing means for sealing the photoelectric conversion device connected to the electric conductor, wherein the photoelectric conversion device performs a transmission of an optical signal between said one side and said other side through the transparent portion of the transparency maintaining unit and the optical pass portion of the electric conductor.

In addition, the optical communication module according to the present invention comprises the transparency maintaining unit provided with a recess portion that accommodates the photoelectric conversion device, and the sealing means provided with a cover that seals the recess portion.

In addition, the optical communication module according to the present invention further comprises one or more electrical circuit components that are connected to an exposure portion of the electric conductor where the electric conductor is exposed outside the recess portion of the transparency maintaining unit.

In addition, the optical communication module according to the present invention further comprises another of the electric conductor, wherein the photoelectric conversion device and the electrical circuit component are electrically connected through the electric conductors, to configure an electrical circuit for the photoelectric conversion.

In addition, the optical communication module according to the present invention comprises the electrical circuit component connected to the electric conductor with a soft solder including a flux.

In addition, the optical communication module according to the present invention further comprises a lens arranged at said other side of the transparency maintaining unit, wherein the photoelectric conversion device performs the transmission of an optical signal between said one side and said other side through the lens, the transparent portion of the transparency maintaining unit and the optical pass portion of the electric conductor.

In addition, the optical communication module according to the present invention comprises the transparency maintaining unit and the lens, both are formed integrally with a transparent resin.

In addition, the optical communication module according to the present invention comprises the optical pass portion being an opening portion larger than the photoelectric conversion unit of the photoelectric conversion device.

In addition, the optical communication module according to the present invention further comprises a cylindrical portion that protrudes at said other side of the transparency maintaining unit and fits therein a communication line for performing an optical communication, wherein the photoelectric conversion device performs the transmission of an optical signal between said one side and said other side through an internal area of the cylindrical portion, the transparent portion of the transparency maintaining unit and the optical pass portion of the electric conductor.

In addition, the optical communication module according to the present invention comprises the cylindrical portion formed integrally together with the transparency maintaining unit.

In addition, the optical communication module according to the present invention comprises: the cylindrical portion having a cylindrical body and plural connection pins protruding from the cylindrical body; the transparency maintaining unit having plural connection holes into which the connection pins are inserted; and the connection pins inserted into the connection holes for connecting the cylindrical body, to arrange the cylindrical portion on the transparency maintaining unit.

In addition, the optical communication module according to the present invention comprises: the connection holes being through holes that penetrate the transparency maintaining unit; and the connection pins passing the connection holes and a tip portion of the connection pins extrude from the transparency maintaining unit after the cylindrical portion is connected to the transparency maintaining unit.

In addition, the optical communication module according to the present invention comprises: the electric conductor formed in a plate shape; the transparency maintaining unit holding the electric conductor whose end portion extends to the outside; and a cylindrical portion that accommodates the transparency maintaining unit at one side of the cylindrical portion and a communication line for the optical communication at the other side of the cylindrical portion, wherein an end surface of said one side of the cylindrical portion is fixed to a portion of the electric conductor extending from the transparency maintaining unit, and the photoelectric conversion device performing the transmission of an optical signal between said one side and said other side through an internal area of the cylindrical portion, the transparent portion of the transparency maintaining unit and the optical pass portion of the electric conductor.

In addition, the optical communication module according to the present invention further comprises a cylindrical portion that is fixed in contact with said other side of the transparency maintaining unit and fits therein a communication line for the optical communication, wherein contact portions of the transparency maintaining unit and the cylindrical portion are flat surfaces, and the photoelectric conversion device performs the transmission of an optical signal between said one side and said other side through an internal area of the cylindrical portion, the transparent portion of the transparency maintaining unit and the optical pass portion of the electric conductor.

In addition, the optical communication module according to the present invention further comprises a positioning unit that protrudes at said one side of the transparency maintaining unit and defines a position for arranging the photoelectric conversion device.

In addition, the optical communication module according to the present invention further comprises a positioning pore that penetrates said one side and said other side of transparency maintaining unit and defines a position for arranging the photoelectric conversion device.

In addition, the optical communication module according to the present invention comprises: the transparency maintaining unit made of transparent resin by utilizing a mold for said one side and another mold for said the other side; and the positioning pore formed with said another mold for said other side of transparency maintaining unit.

In addition, the optical communication module according to the present invention comprises: the transparency maintaining unit having a projection that defines a position for holding the electric conductor; and the electric conductor having a hole portion or a concave portion that fits to the projection of the transparency maintaining unit.

In addition, the optical communication module according to the present invention further comprises a wire that electrically connects the electric conductor to another surface of photoelectric conversion device different from said one surface on which the photoelectric conversion unit and the connector are arranged.

In addition, the optical communication module according to the present invention comprises: the electric conductor being formed in a plate shape; an end portion of the electric conductor extending to the outside the transparency maintaining unit to support the electric conductor; the optical communication module further having a terminal portion connected to an extending portion of electric conductor extending from the transparency maintaining unit; and the terminal portion being thicker than the extending portion of the electric conductor.

In addition, a method for manufacturing an optical communication module is defined by claim 13, the method including: a photoelectric conversion device that is provided with a photoelectric conversion unit and a connector on one surface of the photoelectric conversion device, wherein the photoelectric conversion unit receives or emits light to perform photoelectric conversion from an optical signal to an electrical signal or from an electrical signal to an optical signal, and the connector connects the photoelectric conversion device to another device; an electric conductor that is connected to the connector of the photoelectric conversion device and is provided with an optical pass portion that passes light toward the photoelectric conversion unit of the connected photoelectric conversion device; a transparency maintaining unit that comprises a transparent portion passing light between one side and the other side of the transparency maintaining unit and that holds the electric conductor, wherein a portion connecting the photoelectric conversion device is exposed at said one side, comprises: a connecting step for connecting the connector to the exposed portion of the electric conductor, after determining a position of the photoelectric conversion device to perform a transmission of an optical signal between said one side and said the other side through the transparent portion of the transparency maintaining unit and the optical pass portion of the electric conductor; and a sealing step for sealing the photoelectric conversion device connected to the electric conductor.

In addition, the method for manufacturing the optical communication module according to the present invention comprises: the transparency maintaining unit of the optical communication module provided with a concave portion that accommodates the photoelectric conversion device; and the sealing step utilizing a cover to seal the recess portion.

In addition, the method for manufacturing the optical communication module according to the present invention comprises: the optical communication module having a positioning unit protruding at said one side of the transparency maintaining unit; and a position of the photoelectric conversion device determined to be a position defined by the positioning unit before the photoelectric conversion device is connected, in the connecting step.

In addition, the method for manufacturing the optical communication module according to the present invention comprises a mark provided at said the other side of the transparency maintaining unit of the optical communication module, wherein a position of photoelectric conversion device is determined to be a position defied by the mark through the transparent portion and then the photoelectric conversion device is connected, in the connection step.

In addition, the method for manufacturing the optical communication module according to the present invention further comprises a forming step for forming the transparency maintaining unit made of transparent resin with a mold for said one side and another mold for said the other side, wherein a positioning pore defining the position for arranging the photoelectric conversion device is formed with said another mold for said the other side of the transparency maintaining unit, in the forming step, and a position of the photoelectric conversion device is determined to be a position defined by the positioning pore and then the photoelectric conversion device is connected, in the connecting step.

In addition, the method for manufacturing the optical communication module according to the present invention further comprises: a molding step for integrally molding plural transparency maintaining units with transparent resin; a dice cutting step for performing dice cutting on the integrally-molded transparency maintaining units and separating the transparency maintaining units from each other; and an arranging step for arranging the electric conductor on the separated transparency maintaining unit.

In addition, the method for manufacturing the optical communication module according to the present invention comprises: a projection defining a position for defining the position of electric conductor arranged on each transparency maintaining unit that is formed integrally in the molding step, and a position of the electric conductor determined with a hole portion or concave portion of the electric conductor fit to the projection of transparency maintaining unit, in the arranging step.

In addition, the method for manufacturing the optical communication module according to the present invention comprises a lens integrally formed together with each transparency maintaining unit, in the molding step.

In addition, the method for manufacturing the optical communication module according to the present invention further comprises an electrically connecting step for electrically connecting the electric conductor to another surface using a wire, different from said one surface, of the photoelectric conversion deviceprovided with the photoelectric conversion unit and the connector, wherein the electrically connection step is performed between the connecting step and the sealing step.

In one aspect of the present invention, the photoelectric conversion device is utilized (e.g., laser diode or photodiode), in which the connector for connecting an electric conductor (e.g., lead frame) is arranged on one surface where the photoelectric conversion unit (e.g., light emitting unit, light receiving unit, optical receiver) is arranged. The optical pass portion for passing light (e.g., opening portion or notch) is arranged at the electric conductor that is connected to the photoelectric conversion device. This electric conductor is connected to the transparency maintaining unit having the transparent portion passing light from one side to the other side, and is supported such that the portion connected to the photoelectric conversion device is exposed. The photoelectric conversion device is connected to the portion of electric conductor exposed to the transparency maintaining unit, to perform the light emission or light reception through the transparent portion of transparency maintaining unit and the optical pass portion of electric conductor, and to perform the transmission of an optical signal, and then the photoelectric conversion device is sealed.

Because of this configuration, the transparency maintaining unit can be formed with the electric conductor that is sealed with resin such that, for example, the portion connecting to the photoelectric conversion device is exposed. In addition, the photoelectric conversion device can be connected to the electric conductor after the transparency maintaining unit has been formed. When transparent synthetic resin is selected, the transparent portion can be provided to the transparency maintaining unit. Alternatively, when non-transparent synthetic resin is selected, the transparency maintaining unit can be formed with non-transparent synthetic resin and be connected to the transparent portion that is separately formed. Thus, it is possible to select the synthetic resin for forming the transparency maintaining unit, without considering the heat resistance of photoelectric conversion device. Therefore, it is easy to enhance the ability of precisely forming the shape of transparency maintaining unit. In addition, the transparency maintaining unit can be made of another material (not resin) with another method (not resin molding), in order to enhance the ability of precisely forming the shape of transparency maintaining unit.

In addition, the photoelectric conversion device is connected and fixed to the electric conductor of transparency maintaining unit after the transparency maintaining unit having the transparent portion is precisely formed. Thus, the position of photoelectric conversion device can be determined precisely in reference to the transparent portion, before the photoelectric conversion device is connected. For example, in the case that the lens is formed integrally on the transparent portion, it is possible to precisely determine the positions of lens and photoelectric conversion device. Alternatively, in the case that the separately-formed lens is attached to the transparency maintaining unit, the lens can be attached to the transparency maintaining unit formed precisely, and it is possible to precisely determine the positions of photoelectric conversion device, transparent portion and lens.

For example, captured image of transparency maintaining unit, transparent portion and the like with a camera can be utilized for determining the position of photoelectric conversion device, before the photoelectric conversion device has been connected and fixed. In this method, the photoelectric conversion device can be connected and fixed, within the error range of + 10 µm from the determined position. In addition, it does not require much time for positioning, connecting and fixing. Therefore, it is possible to precisely connect and fix the photoelectric conversion device without increasing the manufacturing cost.

The photoelectric conversion device is sealed after connected to the electric conductor. The sealing may be resin sealing (e.g., potting, transfer molding) or sealing with a cover, cap or the like. Because the sealing is performed after the position of photoelectric conversion device is precisely determined and the photoelectric conversion device is connected, higher precision for sealing is not required. In addition, circuit components for the peripheral circuit may be sealed together with the photoelectric conversion device.

In one aspect of the present invention, the recess portion is provided to the transparency maintaining unit, which accommodates the photoelectric conversion device (although the recess portion is not necessarily required, the recess portion is surrounded by wall portions formed for sealing with the cover described later). Further, a part of the electric conductor is exposed inside the recess portion and the photoelectric conversion device is connected to the exposed part, for arranging the photoelectric conversion device on the transparency maintaining unit. Therefore, the cover sealing the recess portion can be utilized for sealing the photoelectric conversion device. The cover can be fixed easily to the transparency maintaining unit with a connecting method, for example, utilizing ultrasonic welding or adhesive. The higher precision for forming the cover and higher precision for connecting the cover are not required. Therefore, the photoelectric conversion device can be sealed with an easy method not requiring high cost.

In one aspect of the present invention, electrical circuit components are connected to the portion of electric conductor exposed to outside the recess portion of transparency maintaining unit, which include a resistance, capacitor, coil, integrated circuit (IC) and/or the like and configure the electrical circuit. Thus, the optical communication module can include the electrical circuit components arranged on the transparency maintaining unit, i.e., can include the electrical circuit required for performing the optical communication, without including a circuit board and the like. Because it is configured to utilize the electric conductor connecting the photoelectric conversion device for including the electrical circuit components, it is possible to prevent the size of optical communication module from becoming larger.

In one aspect of the present invention, plural electric conductors are provided to the transparency maintaining unit. The plural electric conductors can be utilized as wiring portions of electrical circuit. Thus, it is possible to configure the electrical circuit when the photoelectric conversion device is properly connected to the electrical circuit components with the electric conductors. Hence, the electrical circuit for performing photoelectric conversion (electrical circuit for the performance of photoelectric conversion devicesuch as an amplifier circuit for amplifying the output of photodiode, a driving circuit for the laser diode, or the like is configured with the photoelectric conversion device and electrical circuit components. Therefore, it is possible to prevent the size of optical communication module from becoming larger, to provide the optical communication module having enhanced convenience, and to minimize the size of communication apparatus including such an optical communication module.

In one aspect of the present invention, the electrical circuit component is connected to the electric conductor with soft solder including flux. Thus, circuit components can be connected by a so-called solder reflow method: printing the soft solder including flux on the board; putting circuit components on the printed soft solder; and heating and melting the soft solder to connect the put circuit components.

Generally speaking, the flux utilized in the solder reflow method is not preferred for the photoelectric conversion device, IC chip or the like electrically connected by a wire bonding method and the like. However, the optical communication module according to the present invention is configured with the photoelectric conversion device sealed with the recess portion and cover. Hence, the electrical circuit component can be connected by the solder reflow method after the cover is fixed to the recess portion. Therefore, it is possible to facilitate arrangement of the electrical circuit component in the optical communication module.

In one aspect of the present invention, the lens is arranged on the transparent portion of transparency maintaining unit at one side different from the other side where the photoelectric conversion device is connected. Thus, the position of photoelectric conversion device can be precisely determined in reference to the lens before the photoelectric conversion device is sealed. Therefore, it is possible to enhance the communication performed by the optical communication module.

In one aspect of the present invention, the transparency maintaining unit and lens are integrally formed with transparent resin. Thus, the lens can be formed with the transparency maintaining unit, the whole of which is utilized as the transparent portion and a partial surface of which is formed in a sphere shape. Therefore, it is possible to precisely determine the position of photoelectric conversion device in reference to the lens.

In one aspect of the present invention, the electric conductor is provided with the opening portion utilized as the optical pass portion that passes light to the photoelectric conversion unit of photoelectric conversion device connected to the electric conductor. In addition, the opening portion of electric conductor is larger than the photoelectric conversion unit of photoelectric conversion device. Therefore, the optical communication module can surely output the light emitted from the photoelectric conversion unit of photoelectric conversion device to the outside through the opening portion of electric conductor, or can surely make the photoelectric conversion unit receive the light coming from the outside.

In one aspect of the present invention, the cylindrical portion is configured to protrude at one side different from the other side where the photoelectric conversion device is connected in the transparency maintaining unit of optical communication module. A communication line, such as an optical fiber, can be fit into the cylindrical portion, and the photoelectric conversion device can perform light emission and light reception through the transparent portion of transparency maintaining unit and optical pass portion of electric conductor inside the cylindrical portion, for performing the transmission of optical signals. Therefore, the photoelectric conversion device can emit light to the communication line fit to the cylindrical portion, or can receive light emitted from the communication line. In the case that the cylindrical portion is precisely formed, by just fitting the communication line into the cylindrical portion, a proper position in reference to the photoelectric conversion device can be attained. Therefore, it is possible to facilitate connecting of the optical communication module to the communication line, and to enhance the performance of communication.

In one aspect of the present invention, the cylindrical portion and transparency maintaining unit are formed integrally. Thus, no process is required for determining the position of cylindrical portion on the transparency maintaining unit and for connecting the cylindrical portion to the transparency maintaining unit in the process for manufacturing the optical communication module. Therefore, it is possible to simplify the manufacturing process and to reduce the manufacturing cost. In addition, by just fitting the communication line to the cylindrical portion, the proper position in reference to the photoelectric conversion device can be attained, because the transparency maintaining unit as well as the cylindrical portion can be formed precisely. Therefore, it is possible to surely facilitate connecting of the optical communication module to the communication line, and to surely enhance the performance of communication.

In one aspect of the present invention, the connection pin is provided to the cylindrical body separately manufactured from the transparency maintaining unit, the connection pin is inserted into the connection hole of transparent maintaining unit, to arrange the cylindrical portion at one side of transparency maintaining unit, as the communication line is fit to the cylindrical portion. The connection hole of transparency maintaining unit can be formed precisely during the formation with resin, and the cylindrical body and connection pin of cylindrical portion can be manufactured separately. Thus, it is possible to perform precisely forming. Hence, the cylindrical portion can be precisely connected with utilizing the provided connection pin and connection hole, without adjusting the position in reference to the transparency maintaining portion. Therefore, it is possible to simplify the manufacturing process of optical communication module.

In one aspect of the present invention, the connection hole for connecting the cylindrical portion is a through hole penetrating one side and the other side of transparency maintaining unit. In addition, the connection pin of cylindrical portion inserted into the connection hole is configured to be longer than the depth of connection hole, and is configured to make the tip of connection pin protrude at one side of transparency maintaining unit when the cylindrical portion is connected. Because the connection hole of transparency maintaining unit can be formed precisely, it is possible to utilize the connection pin protruding from the connection hole, as the reference for determining the position when photoelectric conversion device is connected to the electric conductor. Therefore, it is possible to precisely and easily connect the photoelectric conversion device in the manufacturing process of optical communication module.

In one aspect of the present invention, the electric conductor connected to the photoelectric conversion device is formed in a plate shape, and the end portion of electric conductor extends to the outside when the electric conductor is supported by the transparency maintaining unit. At that time, the electric conductor extending to the outside from the transparency maintaining unit is preferably for the power supply potential, ground potential or the like used to supply the electric power to the photoelectric conversion device, but not to transmit the signal of photoelectric conversion device (however, it is not prohibited that the electric conductor is for transmitting the signal of photoelectric conversion device).

The separately-manufactured cylindrical portion is fixed to the electric conductor extending from the transparency maintaining unit by a connecting method, for example, welding, pressure welding or using an adhesive. The cylindrical portion accommodates the transparency maintaining unit at one side where the electric conductor is fixed thereto, and fits therein the communication line for the optical communication at the other side.

Therefore, it is possible to surely fix the cylindrical portion and the optical communication module, even when the communication line is thick and the cylindrical portion for fitting this communication line thereto is larger than the optical communication module.

In one aspect of the present invention, the separately-manufactured cylindrical portion is fixed in contact with the optical communication module of transparency maintaining unit. One side of this cylindrical portion is configured to be in contact with the transparency maintaining unit, and the other side is configured to fit the communication line thereto utilized for the optical communication. The contact region of transparency maintaining unit to the cylindrical portion, as well as the contact region of cylindrical portion to the transparency maintaining unit, is configured to be a flat surface. For example, the transparency maintaining unit and cylindrical portion are fixed by a method utilizing adhesive, welding, or the like.

Because these contact regions of transparency maintaining unit and cylindrical portion are configured to be flat surfaces, it is possible to smoothly move the cylindrical portion to and from the transparency maintaining unit while the transparency maintaining unit is in contact with the cylindrical portion. Therefore, it is possible to smoothly adjust the positions of transparency maintaining unit and of cylindrical portion (to adjust the centers of the photoelectric conversion device of transparency maintaining unit and the cylindrical portion).

In one aspect of the present invention, the transparency maintaining unit of optical communication module includes the positioning unit protruding to define the arrangement position of photoelectric conversion device. Because the transparency maintaining unit of optical communication module can be formed precisely, it is possible to precisely form the positioning unit that is protruding. Thus, the photoelectric conversion device can be precisely connected to the electric conductor based on the positioning unit, in the process for manufacturing the optical communication module. Therefore, it is possible to enhance the communication performance of optical communication module.

In one aspect of the present invention, the transparency maintaining unit of optical communication module includes the positioning pore that defines the arrangement position of photoelectric conversion device. Because the transparency maintaining unit of optical communication module can be formed precisely, it is possible to precisely form the positioning pore. Thus, the photoelectric conversion device can be precisely connected to the electric conductor based on the positioning pore, in the process for manufacturing the optical communication module. Therefore, it is possible to enhance the communication performance of optical communication module.

In one aspect of the present invention, two molds are utilized for forming one side and the other side of transparency maintaining unit made of transparent resin and the positioning pore is formed with the mold for said other side.

Thus, it is possible to determine the position of photoelectric conversion device in reference to the positioning pore formed with the mold dedicated to the other side of transparency maintaining unit, in the case that the lens, cylindrical portion or the like are arranged at said other side of transparency maintaining unit. Therefore, the photoelectric conversion device can be precisely connected to the lens, cylindrical portion or the like, arranged at said other side of transparency maintaining unit.

In one aspect of the present invention, the projection is arranged on the transparency maintaining unit, the hole portion or concave portion is arranged on the electric conductor, and the projection of transparency maintaining unit is engaged into the hole portion or concave portion of electric conductor, for determining the positions of transparency maintaining unit and electric conductor. Thus, it is possible to easily and precisely arrange the electric conductor on the separately-manufactured transparency maintaining unit, for making the transparency maintaining unit hold the electric conductor. Therefore, it is possible not only to enhance the transmission of optical signals performed by the optical communication module, but also to simplify the process for manufacturing the optical communication module and to reduce the cost for the manufacturing process.

All of the electric terminals for transmitting electrical signal to and from and for supplying electric power to the photoelectric conversion device may not be arranged on the surface where the photoelectric conversion unit is arranged. In the case that an electric terminal is arranged on a surface different from the surface where the photoelectric conversion unit is arranged, this electric terminal of photoelectric conversion device is electrically connected to the electric conductor with the wire in one aspect of the present invention. Therefore, it is possible to configure the optical communication module based on the present invention even with the photoelectric conversion device in which an electric terminal is arranged on a surface different from the surface where the photoelectric conversion unit is arranged.

In one aspect of the present invention, the electric conductor connected to the photoelectric conversion device is configured to be in the shape of a plate, the end portion of electric conductor is extending to the outside when the electric conductor is supported by the transparency maintaining unit, and the extension part of electric conductor is utilized as the electric connection terminal of optical communication module. It should be noted that the extension part may have a low strength as the electric connection terminal because the electric conductor supported by the transparency maintaining unit must be thin, for example, about 100 µm. Thus, the separately-manufactured electric terminal portion is connected to the extension part of electric conductor by a connecting method, for example, welding or adhesive, as the electric terminal portion is thicker (for example, 250-400 µm) than the extension part of electric conductor. Therefore, it is possible to enhance the strength of electric connection terminal in the optical communication module.

In one aspect of the present invention, the transparency maintaining unit including the transparent portion and supporting the electric conductor is formed by a method, such as resin molding, and the connector of photoelectric conversion device is connected to the electric conductor exposed at said one side of this transparency maintaining unit in the process manufacturing the optical communication module described above. At that time, the position of photoelectric conversion device is determined and the photoelectric conversion device is connected, to perform the transmission of optical signals through the optical pass portion of electric conductor and the transparent portion of transparency maintaining unit, i.e., to direct the light emitted from the optical emitter of photoelectric conversion device toward said other side through the optical pass portion of transparency maintaining unit and the transparent portion of transparency maintaining unit, or to make the optical receiver of photoelectric conversion device receive the light incident from said other side through the transparent portion of transparency maintaining unit and optical pass portion of electric conductor. Then, the photoelectric conversion device connected to the electric conductor is sealed.

Because the photoelectric conversion device is connected to the previously-manufactured transparency maintaining unit and then sealed, it is possible to precisely determine the position of photoelectric conversion device in reference to the optical pass portion of electric conductor supported by the transparency maintaining unit and the transparent portion of transparency maintaining unit. In addition, it is possible to enhance the ability of precise forming of the transparency maintaining unit, because the material for forming the transparency maintaining unit can be selected regardless of the heat resistance of photoelectric conversion device.

In one aspect of the present invention, the transparency maintaining unit is configured to previously include the recess portion in which the electric conductor is exposed, and the photoelectric conversion device is configured to be accommodated inside the recess portion, to be connected with the electric conductor. The photoelectric conversion device is sealed with the cover sealing the recess portion, which is fixed after the photoelectric conversion device is connected to the electric conductor. The cover can be fixed easily by a method, for example, utilizing ultrasonic welding or adhesive. The sealing of photoelectric conversion device can be implemented by an easy and inexpensive method, because it is not required to precisely fix the cover.

In one aspect of the present invention, the positioning unit is configured to protrude at said one side where the electric conductor is exposed in the transparency maintaining unit of optical communication module. Before the photoelectric conversion device is connected to the electric conductor, the position of photoelectric conversion device is determined in reference to the positioning unit arranged on the transparency maintaining unit. Because the transparency maintaining unit of optical communication module can be formed precisely and the protruding positioning unit can also be formed precisely, it is possible to precisely connect the photoelectric conversion device.

In one aspect of the present invention, a mark (e.g., luminous object or image) is applied at the other side of transparency maintaining unit for connecting the photoelectric conversion device to the electric conductor. This mark is preferred to be applied to a holder or the like, formed to fit to the other side of transparency maintaining unit, for example. The mark applied at said other side of transparency maintaining unit can be utilized as the reference for arranging the photoelectric conversion device, because the mark can be seen through the transparent portion of transparency maintaining unit by a camera or the like. Therefore, it is possible to precisely determine the position of photoelectric conversion device even in the case that the positioning unit described above is not arranged in the transparency maintaining unit.

In one aspect of the present invention, the transparency maintaining unit of optical communication module is molded with transparent resin, using a mold for said one side and another mold for said other side, and said another mold for said other side is utilized for forming the positioning pore on the transparency maintaining unit. Before the photoelectric conversion device is connected to the electric conductor supported by the transparency maintaining unit, the position of photoelectric conversion device is determined in reference to the positioning pore formed on the transparency maintaining unit.

In the case that lens, cylindrical portion or the like is arranged at said other side of transparency maintaining unit, the position of positioning pore formed with said another mold for said other side of transparency maintaining unit is determined precisely in reference to the lens, cylindrical portion and the like. Thus, the position of photoelectric conversion device is determined in reference to the positioning pore, so that the photoelectric conversion device is precisely formed in reference to the lens, cylindrical portion and the like arranged at said other side of transparency maintaining unit.

In one aspect of the present invention, many transparency maintaining units are integrally formed with transparent resin, and then the transparency maintaining units are separated from each other, for manufacturing the transparency maintaining unit in the process for manufacturing the optical communication module. The electric conductor is arranged on each of the separated transparency maintaining units, and is connected to the photoelectric conversion device, and the electric conductor and photoelectric conversion device are sealed, for manufacturing the optical communication module.

Therefore, it is possible to reduce the manufacturing cost for the resin sealing and reduce the cost for manufacturing the optical communication module, in comparison to the case that the resin molding is performed independently for the photoelectric conversion device and for the electric conductor.

In one aspect of the present invention, the projection is integrally formed on the transparency maintaining unit when the transparency maintaining unit is formed with resin, as the projection is configured to engage with the hole portion or concave portion arranged on the electric conductor. Thus, the projection of transparency maintaining unit can be engaged with the hole portion or concave portion of electric conductor to determine the position, in the process for arranging the electric conductor on the transparency maintaining unit. Therefore, it is possible to facilitate manufacturing of the optical communication module and to reduce the cost for manufacturing the optical communication module.

In one aspect of the present invention, the lens is integrally formed with the transparency maintaining unit when the transparency maintaining unit is formed with resin. As described above, the transparency maintaining unit is formed by the resin molding method, separately from the electric conductor and photoelectric conversion device. Thus, it is possible to select the resin having higher precision in the forming ability, regardless of the heat resistance of photoelectric conversion device, and possible to form the lens precisely.

In one aspect of the present invention, the wire is utilized for electrically connecting the electric conductor to a surface different from the surface where the optical emitter or optical receiver of photoelectric conversion device is arranged, after the electric conductor is connected to the photoelectric conversion device, and then the photoelectric conversion device is sealed. All of the electric terminals for transmitting electrical signal to and from and for supplying electric power to the photoelectric conversion device may not necessarily be arranged on the same surface where the photoelectric conversion unit is arranged. In the case that an electric terminal is arranged on a surface different form the surface where the photoelectric conversion unit is arranged, the step of electrically connecting the electric conductor through the wire to the electric terminal of photoelectric conversion device is performed between the step of connecting the photoelectric conversion device and the step of sealing. Therefore, the optical communication module can be manufactured even in the case that the electric terminal is arranged on a surface of photoelectric conversion device different form the surface where the photoelectric conversion unit is arranged.

In one aspect of the present invention, the electric conductor includes the optical pass portion, a part of electric conductor is configured to be exposed after the electric conductor is supported by the transparency maintaining unit including the transparent portion, the photoelectric conversion device is connected to the electric conductor to perform the transmission of optical signals through the optical pass portion of electric conductor and the transparent potion of transparency maintaining unit, and then photoelectric conversion device is sealed. Thus, it is possible to precisely determine the position of photoelectric conversion device and precisely connect the photoelectric conversion device. In addition, the photoelectric conversion device is configured to be connected after the transparency maintaining unit is formed. Therefore, it is possible to select the material of transparency maintaining unit from a wider range, and to precisely form the transparency maintaining unit.

In the case that lens is formed integrally with the transparency maintaining unit, the positions of lens and photoelectric conversion device are precisely determined, and thus it is possible to prevent the communication performance from being deteriorated due to the positional berration. Even in the case that the lens is formed separately, the lens can be fixed to the precisely formed transparency maintaining unit, and thus it is possible to prevent the positional aberrations of lens and photoelectric conversion device.

In the case that the position of communication line (such as the optical fiber) is adjusted to the position of optical communication module, the position of communication line can be determined with respect to the transparency maintaining unit and transparent portion that are precisely formed, and thus it is possible to precisely match the position of communication line and the position of photoelectric conversion device, and to prevent the positional aberrations of communication line and photoelectric conversion device. Particularly, when the cylindrical portion and the like are configured to be arranged on the transparency maintaining unit for fitting the communication line therein, it is possible to easily and surely adjust the position of communication line.

Therefore, the optical communication module according to the present invention can perform the optical communication precisely.

In one aspect of the present invention, the connector of photoelectric conversion device is connected to the electric conductor exposed at one side of transparency maintaining unit for making the optical emitter or optical receiver of photoelectric conversion device perform the transmission of optical signals through the optical pass portion of electric conductor and transparent portion of transparency maintaining unit, and then the photoelectric conversion device connected to the connector of photoelectric conversion device is sealed for manufacturing the optical communication module. Thus, the position of photoelectric conversion device can be determined and the photoelectric conversion device is precisely connected, in reference to the optical pass portion of electric conductor supported by the transparency maintaining unit and the transparent portion of transparency maintaining unit. Therefore, the optical communication module manufactured by this method can precisely perform the optical communication because the positional aberrations of photoelectric conversion device, lens, communication line, and the like are rarely caused.

In addition, because it is configured that the electrical circuit component is connected to the electric conductor exposed outside the peripheral wall of transparency maintaining unit, the optical communication module can include the electrical circuit component by utilizing the electric conductor connecting the photoelectric conversion device, but by utilizing no circuit board. In addition, it is possible to configure the electrical circuit by utilizing these electrical circuit components and electric conductor. Therefore, it is possible to implement the optical communication module, in which the photoelectric conversion device is integrally formed with the electrical circuit component, and which is relatively small, does not require many parts and can precisely perform the optical communication.

In one aspect of the present invention, it is configured that the transparent resin is utilized for integrally forming many transparency maintaining units, and that each of many transparency maintaining units is cut and separated. The electric conductor is arranged on each of the separated transparency maintaining units, the photoelectric conversion device is connected to the electric conductor, and the electric conductor and photoelectric conversion device are sealed. Therefore, it is possible to reduce the manufacturing cost regarding the resin molding in the process of manufacturing the optical communication module. In addition, it is configured that the projection of transparency maintaining unit is engaged to the hole portion or concave portion of electric conductor, for determining the position of electric conductor in reference to the transparency maintaining unit. Thus, it is possible to easily and precisely arrange the electric conductor on each transparency maintaining unit. Therefore, it is possible to enhance the communication performance of optical communication module and to reduce the cost for manufacturing the optical communication module.

The above and further objects and features of the invention will more fully be apparent from the following detailed description with accompanying drawings.

### BRIEF DESCRIPTION OF THE DRAWINGS

FIG. 1 is a schematic cross section view showing a configuration of optical communication module not forming part of the present invention.
FIG. 2A is a schematic view showing a configuration of photoelectric conversion device included in the optical communication module according to the present invention.
FIG. 2B is a schematic view showing another configuration of photoelectric conversion device included in the optical communication module according to the present invention.
FIG. 2C is a schematic view showing another configuration of
FIG. 3 is a schematic flat view showing a configuration of conductive plate included in the optical communication module according to the present invention.
FIG. 4 is a schematic view explaining a method for manufacturing the optical communication module according to the present invention.
FIG. 5 is another schematic view explaining the method for manufacturing the optical communication module according to the present invention.
FIG. 6 is another schematic view explaining the method for manufacturing the optical communication module according to the present invention.
FIG. 7 is a schematic view explaining a method for manufacturing the optical communication module in Variation 1 according to the present invention.
FIG. 8 is a schematic cross section view showing a configuration of optical communication module according to the present invention.
FIG. 9A is a schematic view explaining a process for manufacturing the optical communication module in Variation 2 according to the present invention.
FIG. 9B is a schematic view explaining another process for manufacturing the optical communication module in Variation 2 according to the present invention.
FIG. 10 is a schematic cross section view showing a configuration of the optical communication module not forming part of the present invention.
FIG. 11 is a schematic flat view showing a configuration of conductive plate included in the optical communication module not forming part of the present invention.
FIG. 12 is a schematic cross section view showing a configuration of optical communication module not forming part of the present invention.
FIG. 13 is a schematic cross section view showing a configuration of the optical communication module not forming part of the present invention.
FIG. 14 is a schematic cross section view showing a configuration of the optical communication module not forming part of the present invention.
FIG. 15 is a schematic cross section view showing a configuration of the optical communication module not forming part of the present invention.
FIG. 16 is a schematic cross section view showing a configuration of the optical communication module not forming part of the present invention.
FIG. 17 is a schematic cross section view showing a configuration of the optical communication module not forming part of the present invention.
FIG. 18A is a schematic view showing a configuration of conductive plate included in the optical communication module in Variation 11 according to the present invention.
FIG. 18B is a schematic view showing another configuration of conductive plate included in the optical communication module of Variation 11 according to the present invention.
FIG. 18C is a schematic view showing another configuration of conductive plate included in the optical communication module of Variation 11 according to the present invention.
FIG. 19 is a schematic cross section view showing a configuration of optical communication module in Embodiment 2 according to the present invention.
FIG. 20 is a schematic flat view showing a configuration of optical communication module in the Embodiment 2 according to the present invention.
FIG. 21 is a circuit diagram showing an example of reception circuit configured with the conductive plate of OSA.
FIG. 22 is a schematic view explaining a method for manufacturing the optical communication module in the Embodiment 2 according to the present invention.
FIG. 23 is another schematic view explaining the method for manufacturing the optical communication module in the Embodiment 2 according to the present invention.
FIG. 24 is another schematic view explaining the method for manufacturing the optical communication module in the Embodiment 2 according to the present invention.
FIG. 25 is another schematic view explaining the method for manufacturing the optical communication module in the Embodiment 2 according to the present invention.
FIG. 26 is another schematic view explaining the method for manufacturing the optical communication module in the Embodiment 2 according to the present invention.
FIG. 27 is a schematic cross section view showing a configuration of the optical communication module not forming part of the present invention.
FIG. 28 is a schematic cross section view showing a configuration of the optical communication module not forming part of the present invention.
FIG. 29 is a schematic flat view showing a configuration of conductive plate included by the optical communication module not forming part of
   the present invention.
FIG. 30 is a schematic view explaining a method for manufacturing the optical communication module not forming part of the present invention.
FIG. 31 is another schematic view explaining the method for manufacturing the optical communication module not forming part of
   the present invention.
FIG. 32 is another schematic view explaining the method for manufacturing the optical communication module not forming part of the present invention.
FIG. 33 is another schematic view explaining the method for manufacturing the optical communication module not forming part of the present invention.
FIG. 34 is another schematic view explaining the method for manufacturing the optical communication module not forming part of the present invention.
FIG. 35 is another schematic view explaining the method for manufacturing the optical communication module not forming part of the present invention.
FIG. 36 is a schematic cross section view showing a configuration of optical communication module not forming part of the present invention.
FIG. 37 is a schematic cross section view showing a configuration of optical communication module not forming part of the present invention.
FIG. 38 is a schematic cross section view showing a configuration of optical communication module not forming part of the present invention.

### DESCRIPTION OF THE PREFERRED EMBODIMENTS

### (Embodiment 1)

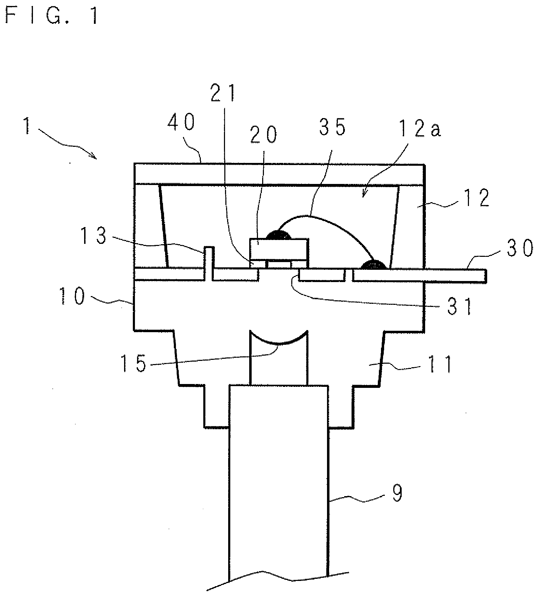

The present invention will be described in reference to figures that show Embodiments according to the present invention. FIG. 1 is a schematic cross section view showing a configuration of optical communication module according to the present invention. The numeral "1" in figures represents an OSA in which a photodiode (photoelectric conversion device) 20 is packaged. The OSA 1 corresponds to an optical communication module according to the present invention. An optical fiber (communication line) 9 is connected to the OSA 1. The OSA 1 is a device for utilizing the photodiode 20 to receive the light emitted from another device through the optical fiber 9, converting an optical signal into an electrical signal and outputting the electrical signal to perform an optical communication.

The OSA 1 includes a plate-shaped basement (transparency maintaining unit) 10 that is approximately square in plain view. The photodiode 20 is connected to one surface of basement 10 (upper surface in FIG. 1; said one surface is simply called the "upper surface", hereinafter), and a protruding cylindrical portion 11 for connecting the optical fiber 9 is formed on the other surface of basement 10 (lower surface in FIG. 1; said other surface is simply called the "lower surface", hereinafter). A peripheral wall 12 is formed along the periphery on the upper surface. The upper surface and peripheral wall 12 of basement 10 configure a recess portion 12a that accommodates the photodiode 20.

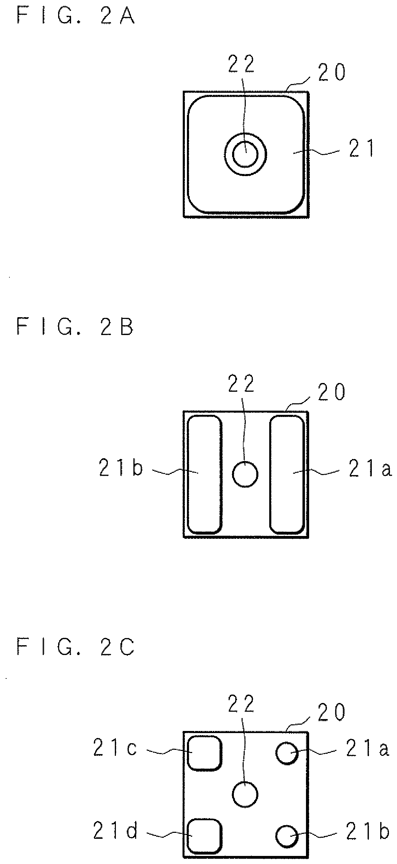

FIGs. 2A-2C are schematic views showing a configuration of photoelectric conversion device included in the optical communication module according to the present invention. They illustrate three examples of configuration about the lower surface of photodiode 20. The photodiode 20 is approximately-square-shaped plate in a plain view. An optical receiver (photoelectric conversion unit) 22 is formed at a substantial center on the lower surface of photodiode 20, which converts an optical signal into an electrical signal in response to detection of light. One or more connectors 21 are arranged around the optical receiver 22. The connector 21 is an electric terminal for inputting and outputting the electrical signal of photodiode 20, and for connecting photodiode 20 to a conductive plate (electric conductor) 30 with soft solder, conductive adhesive or the like.

For example, it is possible to form the connector 21 in an annular shape surrounding the optical receiver 22 (see FIG. 2A). In this example, only one connector 21 can be arranged on the lower surface of photodiode 20. However, the photodiode 20 requires two electric terminals for outputting and inputting signals. Thus, it is required to arrange another connector on the upper surface, side surface or the like. In this Embodiment, another connector (not shown in figures) is arranged on the upper surface of photodiode 20, and a metal wire 35 electrically connects the connector on the upper surface to the conductive plate 30.

Alternatively, two connectors 21a, 21b may be arranged on the lower surface of photodiode 20 (see FIG. 2B). In this alternative case, each of connectors 21a, 21b may be formed in an approximately-rectangular shape and arranged to sandwich the optical receiver 22. Alternatively, dummy connectors 21c, 21d may be arranged, together with the connectors 21a, 21b that are utilized for inputting and outputting electrical signals (see FIG. 2C). The dummy connectors 21c, 21d are utilized for the connection with soft solder, conductive adhesive or the like, but not for inputting and outputting electrical signals. In this later alternative case, four connectors 21a-21d may be arranged at the four corners on the lower surface of photodiode 20.

The following description and figures are explained in the context of OSA 1 including the photodiode 20 shown in FIG. 2A.

A metal conductive plate 30 is implanted into the basement 10 of OSA 1, and one surface of conductive plate 30 is exposed in the recess portion 12a. The conductive plate 30 is connected to the connector 21 of photodiode 20 with soft solder, conductive adhesive or the like at the exposed part thereof in the recess portion 12a, or connected with the wire 35 to the electric terminal arranged, for example, on the upper surface of photodiode 20, for transmitting electrical signals between the photodiode 20 and an external device. In other words, the conductive plate 30 is a wiring for connecting components in the reception circuit that utilizes the photodiode 20.

components in the reception circuit that utilizes the photodiode 20.

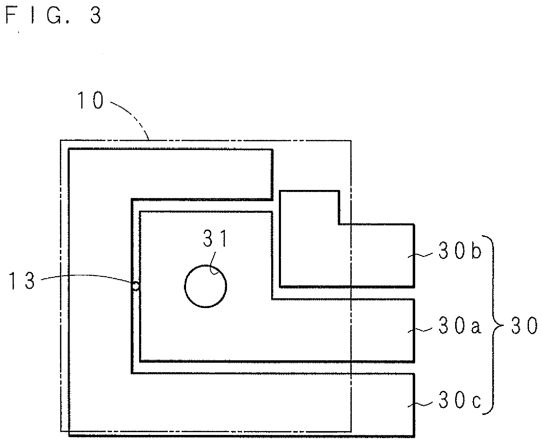

FIG. 3 is a schematic flat view showing a configuration of conductive plate 30 included in the optical communication module according to the present invention. FIG. 3 shows the outline of basement 10 illustrated by the two-dot chain line which is overlaid on the upper surface of conductive plate 30. In the example of figures, the OSA 1 includes three conductive plates 30a-30c. The first conductive plate 30a is configured with a substantially-square part arranged at the center of basement 10 and with an extension part extending from the square part to the outside. An opening portion 31 is formed at the substantial center of square part, which has a substantially-circular shape and works as an optical pass portion for passing light. The first conductive plate 30a is fixed to the basement 10, and the opening portion 31 is located at the substantial center of basement 10 in a plain view. The diameter of opening portion 31 is shorter than one side of photodiode 20 on the lower surface, but longer than the diameter of optical receiver 22 included in the photodiode 20. The connector 21 of photodiode 20 is connected to the periphery of opening portion 31 on the first conductive plate 30a, with soft solder or conductive adhesive.

The second conductive plate 30b is formed in a substantially-"L" shape. The second conductive plate 30b is aligned with the first conductive plate 30a, and one end portion of second electric terminal arranged on the upper surface of photodiode 20 with the wire 35. The third conductive plate 30c is formed in a substantially-"U" shape. The third conductive plate 30c is arranged to surround the first conductive plate 30a and one end portion of third conductive plate 30b is extending from the basement 10 to the outside. The third conductive plate 30c is utilized for the purpose of shielding the OSA 1. For example, the third conductive plate 30c is connected at a ground potential for that purpose. The extension parts of conductive plates 30a-30c extending from the basement 10 are utilized as electric terminals that connect the OSA 1, for example, to a circuit board of communication apparatus.

A positioning unit 13 protrudes into the recess portion 12a from the upper surface of basement 10 included in the OSA 1, and is formed in a round rod shape. The positioning unit 13 is utilized as a positional reference for connecting the photodiode 20 to the conductive plate 30 (30a) within the recess portion 12a. It is configured to accurately define the distance between the center of opening portion 31 on the conductive plate 30 fixed to the basement 10 (or the center of lens 15 described later) and the position of positioning unit 13. For connecting the photodiode 20 to the conductive plate 30, it may be configured to utilize a manufacturing equipment that captures the image of upper surface of basement 10, for example, with a camera and connects the photodiode 20 to the position shifted from the position of positioning unit 13 by a predetermined distance in a predetermined direction. Thus, it is possible to approximately match the center of optical receiver 22 in the photodiode 20 with the center of opening portion 31 on the conductive plate 30, after the photodiode 20 is connected to the conductive plate 30.

The OSA 1 includes the basement 10, cylindrical portion 11, peripheral wall 12 and positioning portion 13 that are configured integrally with transparent synthetic resin. For example, the integral configuration can be implemented by so-called injection molding that is a method for putting the conductive plate 30 previously formed in an arbitrary shape into the mold, pouring transparent liquid resin into the mold and then allowing to cure the transparent resin. When the basement 10 is made of the transparent synthetic resin, the photodiode 20 connected to the conductive plate 30 can receive the light coming from the outside through the transparent basement 10 and the opening portion 31 of conductive plate 30. Furthermore, it is possible to select the synthetic resin configuring the basement 10, cylindrical portion 11 and the like, without considering the heat resistance of photodiode 20. Therefore, it is possible to select and utilize the synthetic resin that has an ability of precise molding and high resistance to environment change, such as temperature change.

In addition, a convex lens 15 is arranged on the lower surface of basement 10. The lens 15 is formed integrally together with the basement 10 by the transparent synthetic resin. On the lower surface of basement 10, the lens 15 is arranged to be opposed to the opening portion 31 of conductive plate 30 arranged on the upper surface of basement 10, i.e., so that the center of lens 15 matches to the center of opening portion 31. Therefore, the lens 15 can collect the light coming from the lower surface side of the basement 10, and the transparent basement 10 and opening portion 31 of conductive plate 30 can pass the light into the optical receiver 22 of photodiode 20. In short, the space between the photodiode 20 connected to the conductive plate 30 of basement 10 and the lens 15 works as a transparent portion that passes the light coming from the outside into the optical receiver 22 of photodiode 20 through the opening portion formed in the conductive plate 30. The diameter of lens 15 is longer than the diameter of optical receiver 22 included in the photodiode 20, and longer than the diameter of opening portion 31 in the conductive plate 30.

The cylindrical portion 11 of OSA 1 is formed in a cylindrical shape, surrounds the lens 15 arranged on the lower surface of basement 10, and protrudes from the lower surface of basement 10. The cylindrical portion 11 is precisely formed, and the center of cylindrical portion 11 approximately matches to the center of lens 15. The cylindrical portion 11 includes a tip section whose inner diameter is enlarged stepwisely. The inner diameter of tip section substantially equals to the diameter of end portion of the optical fiber 9, and the optical fiber 9 can be fit to the tip section. When the optical fiber 9 is fit into the cylindrical portion 11, the center of optical fiber 9 approximately matches with the center of lens 15.

In addition, the OSA 1 includes a cover 40 that is attached to the upper end of peripheral wall 12 arranged on the upper surface side of basement 10 and thus seals the recess portion 12a. The cover 40 is formed in a substantially-square plate shape in a plain view similar to the basement 10, and is attached to the upper end of peripheral wall 12 with a connecting method, for example, by utilizing ultrasonic welding or adhesive. The cover 40 may be transparent or non-transparent, and may be formed with materials as same as or different from those of basement 10, peripheral wall 12 and the like. Gas, such as nitrogen gas or dry air, may be injected into recess portion 12a, when the cover 40 is attached. Alternatively, the inside of recess portion 12a may be configured to be vacuum.

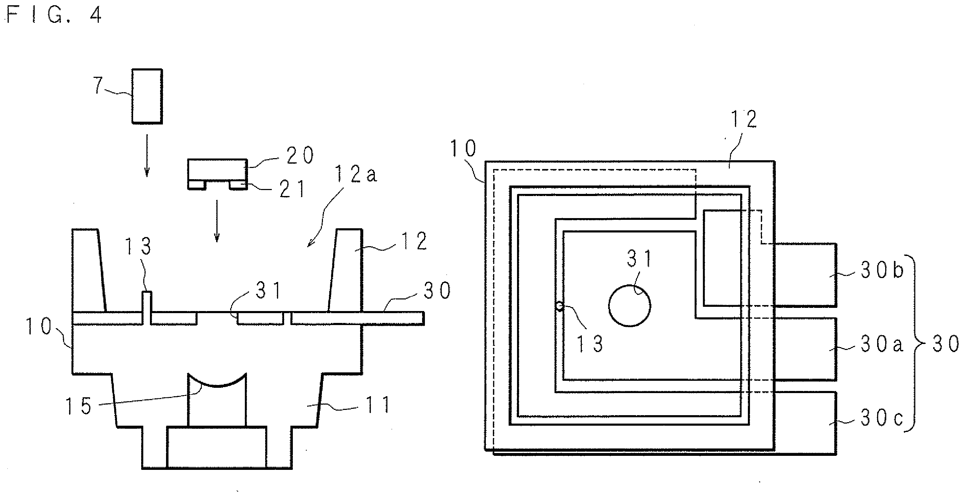

FIGs. 4-6 are schematic views explaining a method for manufacturing the optical communication module according to the present invention. The manufacturing process of OSA 1 is illustrated in the time-series figures from FIG. 4 to FIG. 6. In each of FIGs 4-6, a cross-sectional side view of OSA 1 is illustrated at the left side and a plain view (of upper surface) is illustrated at the right side. In the manufacturing process of OSA 1 according to the present invention, the conductive plate 30 is formed in an arbitrary shape, for example, by processing a metal plate, the formed conductive plate 30 is put into the mold utilized for injection molding, transparent liquid resin is poured into the mold and the poured resin is allowed to cure, to integrally mold the basement 10, cylindrical portion 11, peripheral wall 12, positioning unit 13 and the like (the process is not shown in the figures). In this process, the center of opening portion 31 of conductive plate 30 is configured to precisely match with the center of cylindrical portion 11 and with the center of lens 15, and the positioning unit 13 is configured at a precise position based on these centers.

Then, the position of positioning unit 13 is confirmed by capturing the image of basement 10 from the upper surface side with utilizing a camera 7 or the like, the position of photodiode 20 is determined to be the position predetermined in accordance with the confirmed position, and the electric terminal portion 21 of photodiode 20 is connected to the conductive plate 30 (see FIG. 4). Thus, the center of optical receiver 22 included in the photodiode 20 is configured to precisely match with the center of opening portion 31 of conductive plate 30, with the center of cylindrical portion 11 and with the center of lens 15.

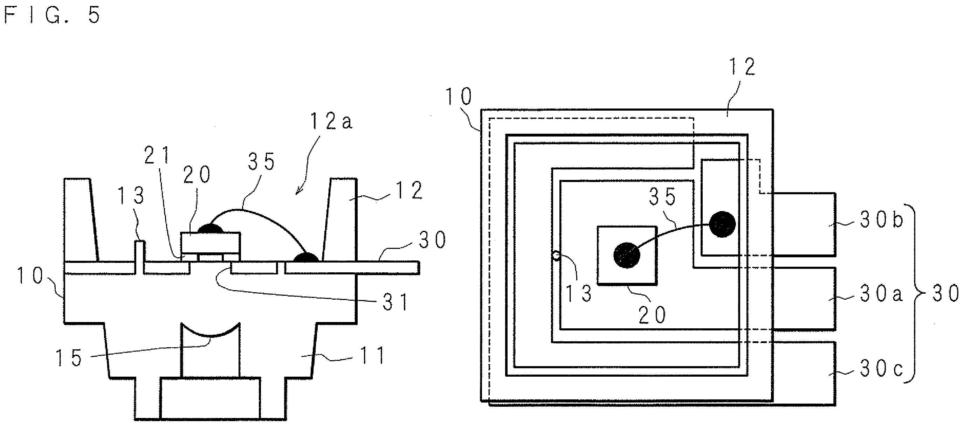

Then, the electric terminal arranged on the upper surface of photodiode 20 is connected, using the wire 35, to the conductive plate 30 (30b) fixed to the basement 10 (see FIG. 5). Thus, the photodiode 20 is electrically connected to the conductive plates 30a, 30b, and the communication apparatus including the OSA 1 can detect the reception of optical signals by detecting the voltage applied between the conductive plate 30a and the conductive plate 30b.

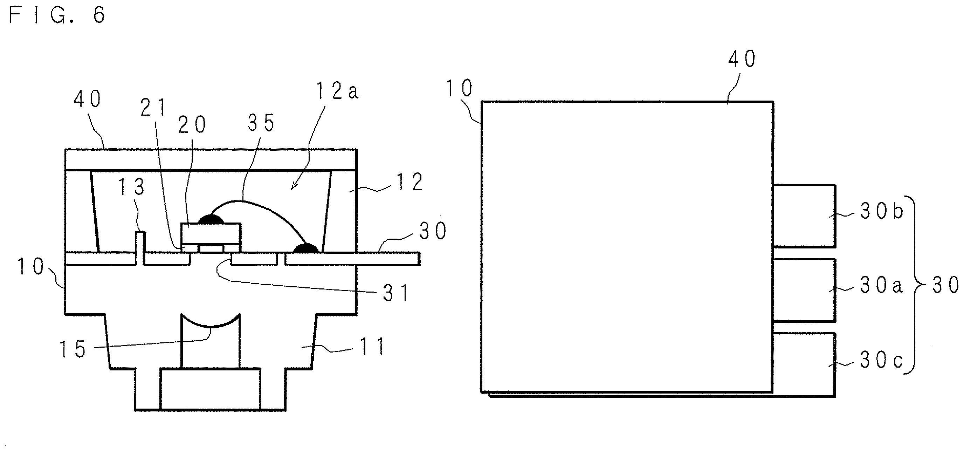

Then, the cover 40 is attached to the upper end of peripheral wall 12 with the connecting method, for example, by utilizing ultrasonic welding or adhesive, to seal the recess portion 12a accommodating the photodiode 20 (see FIG. 6). Thus, the photodiode 20 is isolated from the outside. Gas may be injected into the recess portion 12a before the cover 40 is attached to the peripheral wall 12.

In the OSA 1 described above, the transparent synthetic resin integrally configures the basement 10, peripheral wall 12 and lens 15, and the conductive plate 30 is exposed within the recess portion 12a while being fixed to the basement 10. As including the connector 21 and optical receiver 22 on the lower surface, the photodiode 20 is connected to the periphery of opening portion 31 through the connector 21 within the recess portion 12a, and the center of optical receiver 22 approximately matches with the center of opening portion 31 in the conductive plate 30 and with the center of lens 15. Then, the recess portion 12a is sealed with the cover 40 attached to the peripheral wall 12. Because of these configurations, the OSA 1 can perform precise positioning after the basement 10 is formed, and then can include the photodiode 20 connected to the conductive plate 30. Furthermore, the OSA 1 can utilize the cover 40 to seal the recess portion 12a without the influence on the connected position of photodiode 20. Hence, it is possible to select the synthetic resin utilized for forming the integral configuration, without considering the heat resistance and the like of photodiode 20. Therefore, it is possible to enhance the precision in integral configuration, to form basement 10, lens 15 and the like with high precision, to perform the precise positioning of the photodiode 20 and lens 15, and to improve the performance of optical communication conducted by the OSA 1.

In addition, it is possible to seal the photodiode 20 with an easy and low-cost method, because the cover 40 is attached to the recess portion 12a to seal the photodiode 20 and precise attachement of cover 40 is not required. In addition, it is possible to perform easy and precise connection of photodiode 20 to the conductive plate 30 based on the positioning unit 13, because the positioning unit 13 is arranged on the upper surface of basement 10 to protrude into the recess portion 12a and is formed precisely and integrally with the basement 10.

In addition, it is possible to implement easy and precise positioning of lens 15 and optical fiber 9, because the cylindrical portion 11 is arranged to surround the lens 15 and protrude from the lower surface of basement 10 and the tip section of cylindrical portion 11 is engaged to the optical fiber 8. Furthermore, it is possible to utilize the lens 15 for collecting light emitted from the optical fiber 9, and utilize the photodiode 20 for surely detecting the collected light. Therefore, it is possible to enhance the performance of optical communication conducted by the OSA 1. If the cylindrical portion 11 is formed not integrally (i.e., separately), it is required to determine the position of cylindrical portion 11 with respect to the basement 10 and attach the cylindrical portion 11 to the basement 10. However, the cylindrical portion 11 formed integrally does not require the process of attachement. In short, it is possible to simplify the manufacturing process.

In this Embodiment, the OSA 1 is illustrated to be the photoelectric conversion device that includes the photodiode 20 and receives light. However, the present invention is not limited to the illustration. The photoelectric conversion device may include a laser diode, such as a vertical cavity surface emitting laser (VICSEL) and may emit light. In this Embodiment, the OSA 1 is further illustrated to include one photoelectric conversion device within the recess portion 12a. However, the present invention is not limited to this illustration. The OSA 1 may include plural photoelectric conversion devices. For example, the OSA 1 may include both the photodiode and laser diode, as the photoelectric conversion devices. This allows the OSA 1 to emit light and receive light to perform the transmission of optical signals.

The configuration of conductive plate 30 (30a-30c) in FIG. 3 is an example, and the present invention is not limited to this example. In addition, although it is illustrated that the photodiode 20 is connected and then the center of opening portion 31 of conductive plate 30 approximately matches with the center of optical receiver 22 of photodiode 20, the center of optical receiver 22 may not necessarily match with the center of opening portion 31 as long as the center of receiver 22 approximately matches with the center of lens 15. In addition, although it is illustrated to connect the electric terminal on the upper surface of photodiode 20 to the conductive plate 30 with the wire 35, the present invention is not limited to the illustration. When plural connectors 21 are arranged on the lower surface of photodiode 20, the wire 35 may be not utilized for the connection.

In addition, although it is illustrated that the opening portion 31 is formed as the optical pass portion in the conductive plate 30 and the optical receiver 22 of photodiode 20 receives light through the opening portion 31, the present invention is not limited to the illustration. For example, a notch, groove or the like may be formed on the conductive plate 30, as the optical pass portion, for receiving light. Alternatively, in the case that plural connectors 21 are arranged on the lower surface of photodiode 20 and each connector is connected to a different conductive plate 30, the optical receiver 22 of photodiode 20 may receive light through the gap between conductive plates 30, as the optical pass portion. Alternatively, in the case that a part or whole of formed conductive plate 30 is transparent, such the transparent portion may be utilized as the optical pass portion for passing the light to the photodiode 20.

In addition, although it is illustrated that the positioning unit 13 protrudes from the upper surface of basement 10 and the photodiode 20 is connected in reference to the position of positioning unit 13, the present invention is not limited to this illustration. Another method may be utilized for determining the position of photodiode 20.

### (Variation 1)

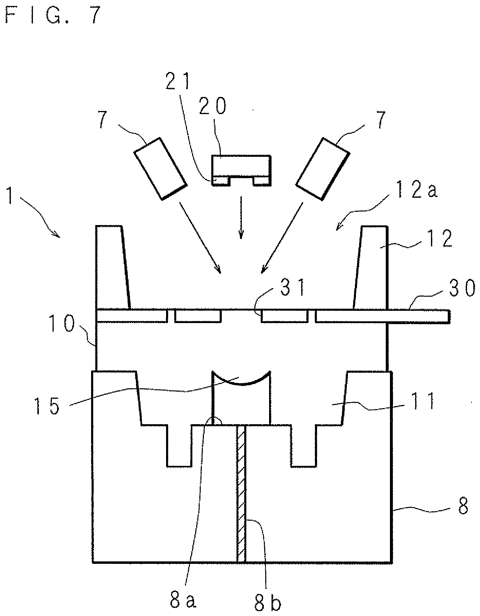

FIG. 7 is a schematic view explaining a method for manufacturing the optical communication module of Variation 1 according to the present invention. The OSA 1 in the Variation 1 does not include the positioning unit 13 on the upper surface of basement 10. Instead, a holder 8 is utilized for determining the position of photodiode 20, when the photodiode 20 is connected to the conductive plate 30.

The holder 8 for determining the position is fitted over the cylindrical portion 11 protruding from the lower surface of basement 10 and includes a concave portion that fits internally to the large diameter section of cylindrical portion 11. The holder 8 includes an opposing surface 8a that is formed in a substantially-circular shape. When the cylindrical portion 11 of OSA 1 is fitted to the concave portion, the opposing surface 8a faces to the lens 15 arranged on the lower surface of basement 10. An optical fiber 8b is imbedded into the holder 8, and the tip of optical fiber 8b is exposed from the center of opposing surface 8a to the outside. The position of optical fiber 8b on the opposing surface 8a is the center of lens 15 in the OSA 1 where the concave portion of holder 8 is fitted to the cylindrical portion 11.

In the case that the photodiode 20 is connected to the conductive plate 30, the cylindrical portion 11 of OSA 1 is fitted to the concave portion of holder 8 and light is emitted to the lens 15 of OSA 1 through the optical fiber 8b of holder 8. Thus, the light from the holder 8 can be recognized through the transparent basement 10 from the upper surface side of basement 10 included in the OSA 1. Thus, the camera 7 is arranged at the upper surface side of basement 10. The camera 7 captures images, the center position of lens 15 is determined in accordance with the light collected by the lens 15, and the photodiode 20 is connected to match with the center position. In the case that two or more cameras 7 are utilized and images are captured from different directions by these cameras 7, it is possible to enhance the accuracy in positioning of photodiode 20 because the center position of lens 15 can be recognized with plural images.

The OSA 1 in the Variation 1 described above does not include the positioning unit 13. However, it is possible to implement the precise connection to the conductive plate 30 of photodiode 20 because the positional determination is performed with the holder 8 for emitting light to the center of lens 15. Although the holder 8 is illustrated to be arranged for emitting light to the center of lens 15, the present invention is not limited to the illustration. The position at which the light is emitted with the holder 8 may be anywhere light can pass from the lower surface side to the upper surface side of basement 10. In addition, the positional determination may not utilize the light emitted from the optical fiber 8b of holder 8. Instead, a mark may be drawn as a reference position on the opposing surface 8a and the camera 7 may capture an image of this mark through the lens 15 to recognize the reference position.

### (Variation 2)

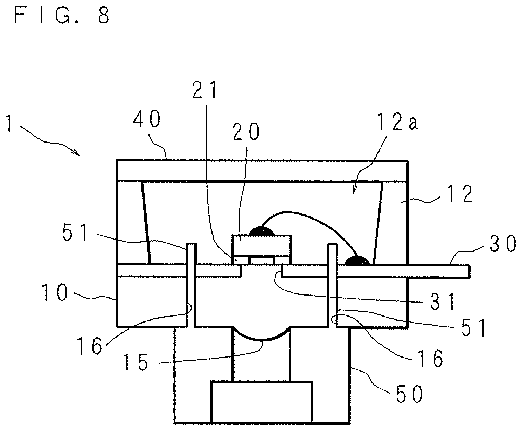

The OSA 1 in the Embodiment 1 described above is illustrated to include the cylindrical portion 11 that is formed integrally with the basement 10. However, the present invention is not limited to the illustration. The cylindrical portion 11 may be formed separately from the basement 10. FIG. 8 is a schematic cross section view showing a configuration of optical communication module in Variation 2 according to the present invention. The OSA 1 in the Variation 2 does not includes the cylindrical portion 11 formed integrally together with the basement 10. Instead, a cylindrical portion 50 is formed separately and is connected to the lower surface of basement 10. Furthermore, the OSA 1 in the Variation 2 does not include the positioning unit 13.

The cylindrical portion 50 is formed in a cylindrical shape, and plural connection pins 51 protrude from the upper surface of cylindrical portion 50. Each connection pin 51 is formed in a round rod shape. Each connection pin is arranged on the upper surface of cylindrical portion 50 and is kept away from another connection pin by the same distance in the circumferential direction. In addition, plural connection hole 16 are formed in the basement 10, which are utilized for inserting the connection pins 51 of cylindrical portion 50. The length of connection pin 51 is larger than the width of basement 10. Thus, when the connection pin 51 is inserted into the connection hole 16 of basement 10, the tip of connection pin 51 extrudes from the upper surface of basement 10.

The tip section (lower section) of cylindrical portion 50 has an inner diameter enlarged stepwisely, and the upper section of cylindrical portion 50 has an inner diameter similar to or a little longer than the diameter of lens 15 arranged on the basement 10. The inner diameter of lower section in the cylindrical portion 50 is approximately equal to the diameter of optical fiber 9, and the cylindrical portion 50 utilizes the larger inner diameter to fit the optical fiber 9.

The connection pin 51 of cylindrical portion 50 is inserted into the connection hole 16 of basement 10 and is fixed to the basement 10 with adhesive or the like, for connecting the cylindrical portion 50 to the basement 10. At that time, it is not required to care for aligning positions of the cylindrical portion 50 and basement 10. The position of connection hole 16 is set in the basement 10, to make the center of lens 15 aligned with the center of cylindrical portion 50 when the connection pin 51 is just inserted into the connection hole 16.

In the manufacturing process, the cylindrical portion 50 is connected to the basement 10 before the photodiode 20 is connected to the conductive plate 30. The connection pin 51 of cylindrical portion 50 protrudes from the upper surface of basement 10 and is utilized as an alternative for positioning unit 13 of OSA 1 in the Embodiment 1. In other words, when the photodiode 20 is connected to the conductive plate 30, the camera 7 captures one of connection pins 51 protruding from the upper surface of basement 10, and the connection position of photodiode 20 is determined in reference to the position of connection pin 51.

In the OSA 1 in the Variation 2 described above, it is possible to implement the easy and sure connecting process of cylindrical portion 50 even with the cylindrical portion 50 formed separately from the basement 10, because the connection pin 51 is arranged to protrude from the surface of the cylindrical portion 50, the connection hole 16 is formed in the basement 10, and the connection pin 51 is inserted into the connection hole 16 for connecting the cylindrical portion 50 to the basement 10. Furthermore, it is possible to select the material of cylindrical portion 50 more freely than the material of basement 10 and thus to implement more precise forming, because the cylindrical portion 50 can be made separately and does not require the transparency. Moreover, it is possible to utilize the connection pin 51 as the reference for determining the position of photodiode 20, because the connection pin 51 of cylindrical portion 50 extrudes from the upper surface of basement 10.

### (Variation 3)

Although the OSA 1 in the Variation 2 described above is illustrated to utilize the connection pin 51 of cylindrical portion 50 connected to the basement 10 as the reference for determining the position of photodiode 20, the present invention is not limited to the illustration. The OSA 1 in Variation 3 is configured to utilize the connection hole 16 formed in the basement 10 as the reference for determining the position of photodiode 20.

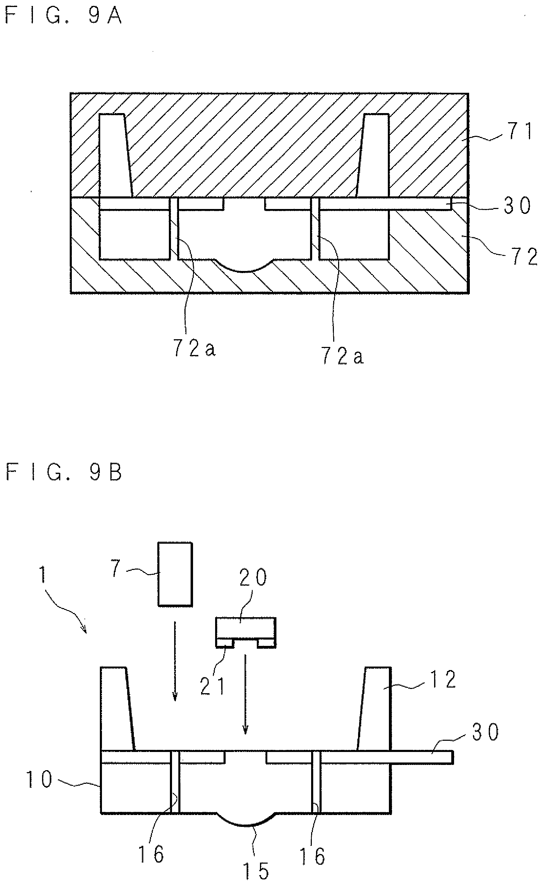

FIG. 9A and FIG. 9B are schematic views explaining a process for manufacturing the optical communication module of Variation 3 according to the present invention. The manufacturing process of OSA 1 in the Variation 3 puts the previously-formed conductive plate 30 into a mold utilized for injection molding, pouring transparent liquid resin into the mold, to allow the resin to cure, in order to form the integral configuration of basement 10, peripheral wall 12, lens 15 and the like (see FIG. 9A). The mold utilized for this process is configured with an upper mold 71 and lower mold 72 that are stacked with each other upper and lower. The upper mold 71 is utilized for forming the peripheral wall 12 of OSA 1 and the like, and the lower mold 72 is utilized for forming the basement 10, lens 15 and the like.

A rod-like protrusion 72a is formed on the lower mold 72, which is utilized for forming the connection hole 16 of basement 10. Thus, it is possible to utilize just the single lower mold 72 for forming the lower surface and side surface of basement 10, the lens 15 and the connection hole 16 of basement 10 in the OSA 1. Therefore, it is possible to precisely set the relative position of lens 15 and connection hole 16.

Then, the position of connection hole 16 in the basement 10 is confirmed with the image captured from the upper surface side of basement 10 by, for example, the camera 7. The photodiode 20 is arranged at a predetermined position with respect to the reference position, and the electric terminal portion 21 of photodiode 20 is connected to the conductive plate 30 (see FIG. 9B). Therefore, it is possible to precisely match the center of optical receiver 22 in the photodiode 20 with the center of lens 15.

Then, cylindrical portion 50 similar to that in Variation 2 is connected to the basement 10 with the connection pin 51 inserted into the connection hole 16, the electric terminal on the upper surface of photodiode 20 is connected with the wire 35 to the conductive plate 30 fixed to the basement 10, and the cover 40 is attached to the upper end of peripheral wall 12, for manufacturing the OSA 1 (these processes are not shown in figures).

The OSA 1 in the Variation 3 described above includes the rod-like protrusion 72a in the lower mold 72 utilized for forming the lower surface of basement 10, lens 15 and the like. The lower mold 72 is utilized for forming the connection hole 16 of basement 10, and the position of photodiode 20 is determined in reference to the position of connection hole 16. Therefore, it is possible to arrange the photodiode 20 with high precision in reference to the lens 15.

Although the Variation 3 is illustrated to utilize the rod-like protrusion 72a in lower mold 72 for forming the connection hole 16 and to determine the position of photodiode 20 based on the position of connection hole 16, the present invention is not limited to the illustration. The reference for determining the position of photodiode 20 may be any position other than the connection hole 16, as long as the portion is formed with the lower mold 72.

### (Variation 4)

In the Variation 2 and Variation 3 described above, the separately-formed cylindrical portion 50 can be connected without the positional determination based on the basement 10 because the connection pin 51 of cylindrical portion 50 is inserted into the connection hole 16 of basement 10. However, if the formation of cylindrical portion 50 is not precise or the like, it may be preferred to adjust the position of basement 10 and the position of cylindrical portion 50, i.e., to match the center of basement 10 with the center of cylindrical portion 50. The OSA 1 in Variation 4 is configured in consideration of positional adjustment for the basement 10 and cylindrical portion 50.

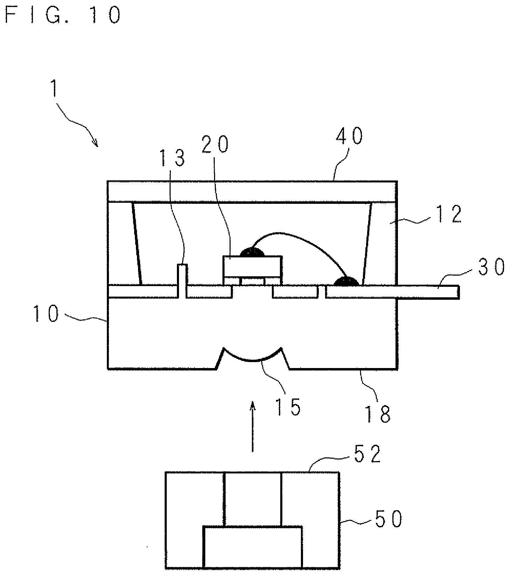

FIG. 10 is a schematic cross section view showing a configuration of the optical communication module in the Variation 4 according to the present invention. The OSA 1 in the Variation 4 includes the basement 10 whose lower surface around the lens 15 is extruding below the lens 15. In other words, the lens 15 of OSA 1 in the Variation 4 is arranged within a concave portion that is formed in a mortar shape on the lower surface of basement 10.

In addition, the connection pin 51 is not included in the cylindrical portion 50 fixed to the basement 10 of OSA 1 in the Variation 4. Furthermore, the connection hole 16 is not formed in the basement 10. The lower surface of basement 10 is a smooth flat surface 18, and the upper surface of cylindrical portion 50 is also a smooth flat surface 52. Thus, the cylindrical portion 50 can be moved smoothly in a direction substantially perpendicular to the longitudinal direction of lens 15 and cylindrical portion 50 with the upper surface of the cylindrical portion 50 being in contact with the lower surface of basement 10, in order to match these center portions with each other. Therefore, it is possible to reduce the moving range for alignment of these centers and to implement the efficient manufacturing, even in the case that these centers should be aligned for the single-mode fiber, multimode fiber with the core having a small diameter or the like.

Although the Variation 4 is illustrated to include the basement 10 whose lower surface is extruding below the lens 15, the present invention is not limited to the illustration. In the case that the inner diameter of cylindrical portion 50 is sufficiently longer than the lens 15, the lens 15 may be extruding below the lower surface of basement 10.

### (Variation 5)

The separately-formed cylindrical portion 50 is illustrated to be smaller than the basement 10 of OSA 1 in the Variations 2-4 described above. However, it may be preferred to prepare the cylindrical portion larger than the basement 10, based on the types of optical communication line (especially, line size). The OSA 1 in the Variation 5 is configured to utilize the cylindrical portion larger than the basement 10.

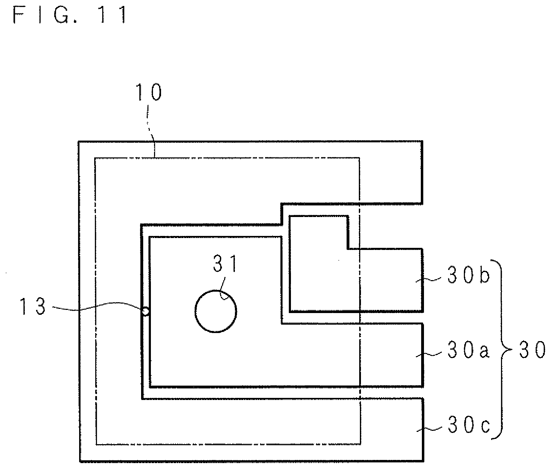

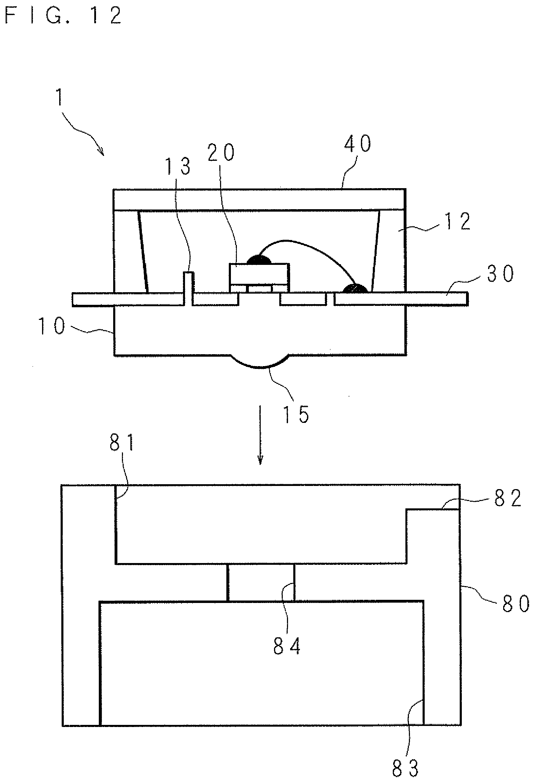

FIG. 11 is a schematic flat view showing a configuration of conductive plate 30 included in the optical communication module of Variation 5 according to the present invention. FIG. 11 shows the outline of basement 10 illustrated by the two-dot chain line which is overlaid on the upper surface of conductive plate 30. FIG. 12 is a schematic cross section view showing a configuration of optical communication module in the Variation 5 according to the present invention.

Similar to the OSA 1 of Embodiment 1 shown in FIG. 3, the OSA 1 in the Variation 5 includes three conductive plates 30a-30c. The first conductive plate 30a and second conductive plate 30b are similar to those shown in FIG. 3, and each includes an extension part extending to the outside from one side surface of basement 10 formed in a substantially-square shape in the view of upper surface. The extension part is utilized as the electric terminal of OSA 1.

The third conductive plate 30c of OSA 1 in the Variation 5 includes an extension part extending to the outside from one side surface of basement 10, similarly to the first conductive plate 30a and second conductive plate 30b. Furthermore, the third conductive plate 30c includes extension parts extending to the outside from the other three side surfaces of basement 10. In other words, the third conductive plate 20c is extending in a flange shape from the three side surface of the basement 10.

The cylindrical portion 80 of OSA 1 in the Variation 5 is formed in a substantially-cylindrical shape, and has the outer diameter larger than the width (horizontal length in FIG. 12) of basement 10 in the OSA 1. A recess portion 81 is formed at one side (upper surface side) of cylindrical portion 80, and is utilized for accommodating the basement 10. A fitting portion 83 is formed at the other side (lower surface side) of cylindrical portion 80, which is utilized for fitting receiving the optical communication line. The recess portion 81 communicates to the fitting portion 83 through a through hole 84. The through hole 84 is configured to extend on the center (shaft center) of cylindrical portion 80.

The recess portion 81 of cylindrical portion 80 is a little larger than the basement 10 and can accommodate the basement 10. Thus, the position of basement 10 can be adjusted within the recess portion 81. In addition, the opening area of recess portion 81 is smaller than the conductive plate 30 extending from the side surface of basement 10. Thus, the extension part of conductive plate 30 comes in contact with the upper surface of cylindrical portion 80, when the basement 10 is accommodated in the recess portion 81.

A cut portion 82 is formed on the upper surface of cylindrical portion 80, and communicates the recess portion 81 to the outside. The cut portion 82 is formed in reference with the position arranging extension parts of the first conductive plate 30a and the second conductive plate 30b extending from the basement 10 when the basement 10 of OSA 1 is housed in the recess portion 81. Thus, only the third conductive plate 30c comes in contact with the upper surface of cylindrical portion 80, while the extension parts of first conductive plate 30a and second conductive plate 30b do not touch the upper surface of cylindrical portion 80, even when the basement 10 is accommodated in the recess portion 81.

In the manufacturing process of OSA 1, the third conductive plate 30 is fixed to the upper surface of cylindrical portion 80 by welding, glueing or the like, after the basement 10 is accommodated in the recess portion 81 of cylindrical portion 80 and then adjusted the position to match the center. It is preferred that the third conductive plate 30c is electrically connected with a stabilized electric potential, such as the ground potential.

The OSA 1 in the Variation 5 described above includes the cylindrical portion 80 that is larger than the basement 10 and can be fixed to the third conductive plate 30 extending from the basement 10. Furthermore, the OSA 1 in the Variation 5 can utilize the cylindrical portion 50 that is illustrated in the Variations 2 and 4 and is smaller than the cylindrical portion 50, with the configurations similar to those of Variations 2 and 4 (the extension part of third conductive plate 30c may be removed if unnecessary). Therefore, there is an advantage that the OSA in the Variation 5 has high versatility.

Although it is illustrated that the cut portion 82 is formed on the cylindrical portion 80, the present invention is not limited to the illustration. Instead, the first conductive plate 30a and second conductive plate 30b may be configured to be bendable for preventing them from being in contact with the cylindrical portion 80.

### (Variation 6)

The OSA 1 according to the Embodiment described above is illustrated to utilize the extension part of conductive plate 30 extending from the basement 10 as the electric terminal for connecting the conductive plate 30 to the circuit board and the like. However, the conductive plate 30 also should be thinner for reducing the size of OSA 1. Thus, the extension part of conductive plate 30 may not possess the strength enough for working as the electric terminal. The OSA 1 in the Variation 6 is configured to implement increased strength of electric terminal.

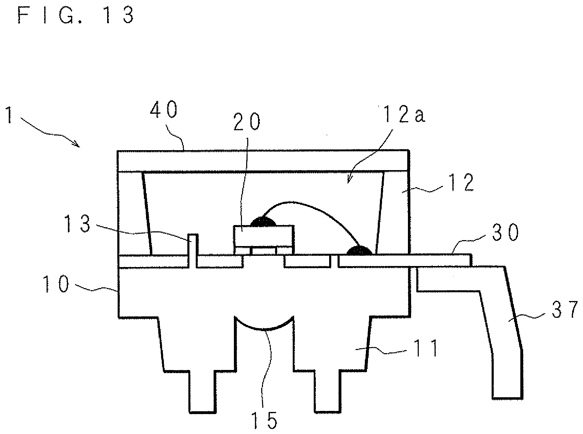

FIG. 13 is a schematic cross section view showing a configuration of the optical communication module in the Variation 6 according to the present invention. Although the OSA 1 in the Variation 6 utilizes the configurations similar to those of OSA 1 shown in FIG. 1, there is a difference that the conductive plate 30 extending from the basement 10 is connected to another part, a terminal portion 37. The terminal portion 37 is made of a conductive material, and is fixed to the conductive plate 30 extending from the basement 10 by welding, using an adhesive or the like. In addition, the conductive plate 30 is configured with plural plates, for example, the first conductive plate 30a, second conductive plate 30b and third conductive plate 30c, while the terminal portion 37 is connected to each of these plural plates of conductive plate 30, respectively.

The terminal portion 37 is configured to be thicker than the conductive plate 30. For example, the thickness of terminal portion 37 is about 250-400 µm when the thickness of extension part included in the conductive plate 30 is about 100 µm. Therefore, it is possible to utilize the terminal portion 37 possessing a higher strength for connecting the OSA 1 to the circuit board and the like.

The thicknesses of conductive plate 30 and terminal portion 37 described above are examples, and the present invention is not limited to these thicknesses. The terminal portion 37 may have any thickness that is at least larger than the thickness of extension part included in the conductive plate 30. The shape of terminal portion 37 shown in FIG. 13 is an example, and the present invention is not limited to this shape.

### (Variation 7)

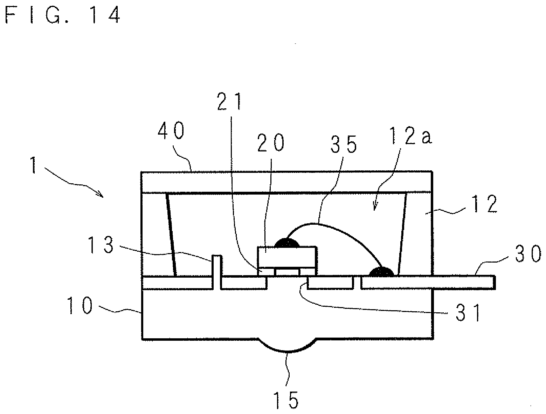

FIG. 14 is a schematic cross section view showing a configuration of the optical communication module in Variation 7 according to the present invention. Although utilizing the configurations similar to those of OSA 1 in the Embodiment 1 described above, the OSA 1 in the Variation 7 does not include the cylindrical portion 11. This Variation requires the positional adjustment of OSA 1 and optical fiber 9, and the communication performance is dependent on the positional adjustment. However, precise adjustment has been performed for the photodiode 20 and lens 15. Therefore, it is expected to enhance the communication performance. Because of these reasons, the OSA 1 may not include cylindrical portion 11.

### (Variation 8)

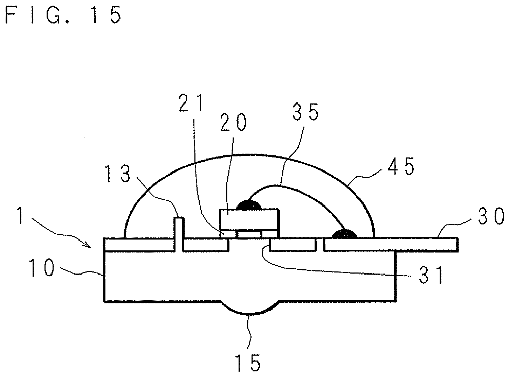

FIG. 15 is a schematic cross section view showing a configuration of the optical communication module in a Variation 8 according to the present invention. Although the OSA 1 in the Embodiment 1 described above is illustrated to utilize the cover 40 for sealing the photodiode 20, the present invention is not limited to the illustration. The OSA 1 in the Variation 8 is configured to include a sealing unit 45 that seals the photodiode 20 with plastic seal, but not to include the cover 40. The basement 10 of OSA 1 in the Variation 8 does not include the peripheral wall 12 on the upper surface. The conductive plate 30 is exposed on the upper surface of basement 10, and the positioning unit 13 protrudes from the upper surface of basement 10. In the manufacturing process of OSA 1 in the Variation 8, the photodiode 20 is connected to the conductive plate 30 in reference to the positioning unit 13, and the wire 35 is utilized for connecting the photodiode 20 and conductive plate 30. Then,a synthetic resin is applied to cover the positioning unit 13, photodiode 20 and wire 35 arranged on the upper surface of basement 10 and is cured for sealing. The heat resistance provided to the photodiode 20 should be considered in selecting the synthetic resin utilized for the sealing. However, the sealing unit 45 does not require the transparency. In addition, it is not required to precisely form the sealing unit 45. Therefore, it is possible to perform the selection in preference to the strength, cost and the like. Although the OSA 1 in FIG. 15 does not include the cylindrical portion 11, the cylindrical portion 11 may be configured integrally with or separately from the basement 10.

### (Variation 9)

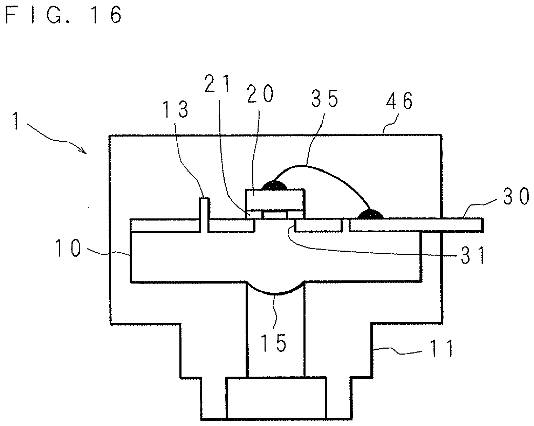

FIG. 16 is a schematic cross section view showing a configuration of the optical communication module in Variation 9 according to the present invention. The OSA 1 in the Variation 9 includes the photodiode 20 that is connected to the conductive plate 30 and is sealed with synthetic resin, similarly to the OSA 1 in the Variation 8, and also includes the cylindrical portion 11 formed with synthetic resin utilized for the sealing. The OSA 1 in the Variation 9 includes a sealing unit 46 that covers not only the photodiode 20 but also almost the whole of the basement 10, except for the lens 15. The sealing unit 46 is configured in a substantially-rectangular parallelepiped shape, and the protruding cylindrical portion 11 is configured to protrude on the lower surface of sealing unit 46. The cylindrical portion 11 surrounds the lens 15 arranged on the lower surface of basement 10, and includes a section engaged with the optical fiber 9 at the tip. The sealing unit 46 does not require transparency.

### (Variation 10)

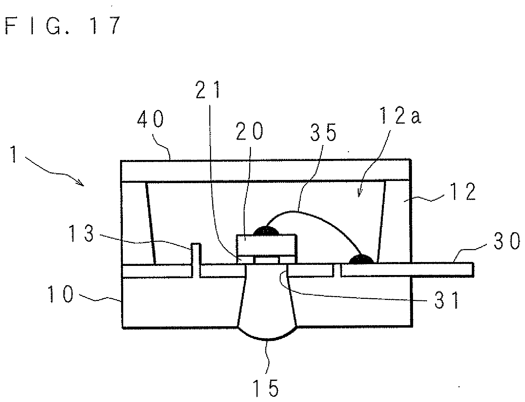

FIG. 17 is a schematic cross section view showing a configuration of the optical communication module in Variation 10 according to the present invention. Although the OSA 1 described above in the Embodiment 1 is illustrated to include the basement 10 and lens 15 that are integrally formed with transparent synthetic resin, the present invention is not limited to the illustration. The OSA 1 in the Variation 10 includes the basement 10, peripheral wall 12 and positioning unit 13 that are integrally formed with non-transparent synthetic resin, while the basement 10 includes a through hole horizontally penetrating through the opening portion 31 of conductive plate 30 and the separately-formed lens 15 fits to and is fixed to the through hole of basement 10. The lens 15 can be formed in a cylindrical shape or frustoconical shape whose one surface is a hemispherical convex surface, and the lens 15 can be fixed to the basement 10 with adhesive or the like. Thus, it is possible to arrange the transparent portion and lens 15 on the basement 10. The basement 10 and lens 15 can be formed with most suitable materials, respectively.

### (Variation 11)

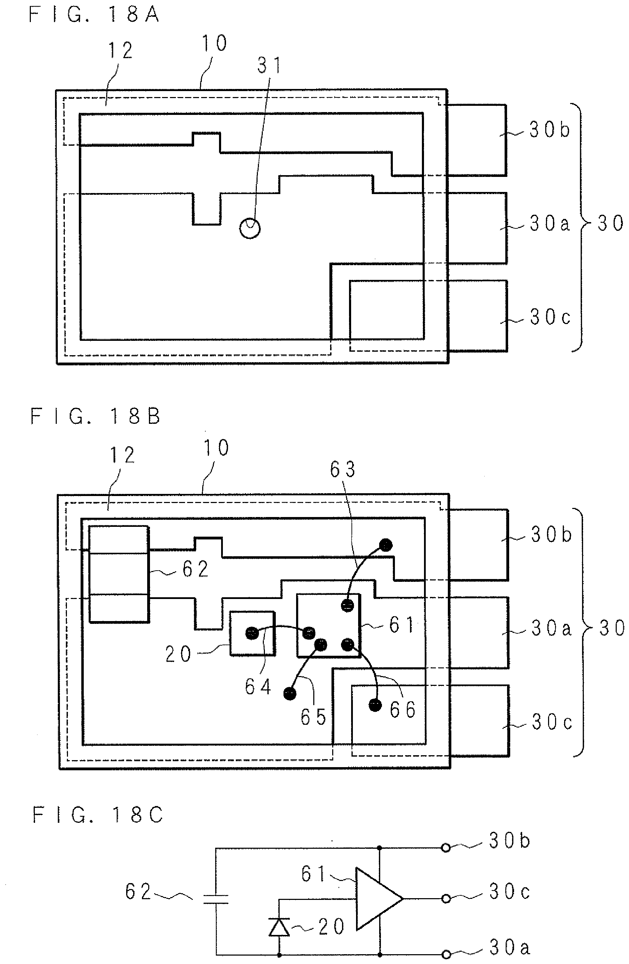

Although the OSA 1 described above in the Embodiment 1 is illustrated to contain the photodiode 20 inside the recess portion 12a, the present invention is not limited to the illustration. It is possible to contain another electrical circuit component (such as a resistance, capacitor, coil, or integrated circuit [IC]) inside the recess portion 12a. FIGs. 18A-18C are schematic views showing a configuration of conductive plate included in the optical communication module of Variation 11 according to the present invention. FIG. 18A shows only the peripheral wall 12 of basement 10 and the conductive plate 30 in a plain view, FIG. 18B shows the photodiode 20 and another circuit component arranged on the configuration shown in FIG. 18A in a plain view, and FIG. 18C shows a circuit diagram representing the configuration of FIG. 18B.

The OSA 1 in the Variation 11 includes three conductive plates 30a-30c that are fixed on the basement 10. The first conductive plate 30a includes the opening portion 31 utilized for passing light into the optical receiver 22 of photodiode 20, and includes the extension part that is extending to the outside of the basement 10. The second conductive plate 30b is aligned in parallel with the second conductive plate 30a, and one end thereof is extending to the outside of basement 10. The third conductive plate 30c formed in a substantially-rectangular shape is aligned in parallel with the first conductive plate 30a at the side opposite to the second conductive plate 30b, and one end thereof is extending to the outside of basement 10. The extension parts of conductive plates 30a-30c extending from the basement 10 are utilized as the electric terminals, for example, for connecting the OSA 1 to a circuit board of communication apparatus.

The OSA 1 in the Variation 11 contains the photodiode 20 and other electrical circuit components (amplifier IC 61 and capacitor 62) inside the recess portion 12a, which are connected properly to three conductive plates 30a-30c, to configure a circuit receiving optical signals. The photodiode 20 includes an anode of electric terminal (connector 21) on the lower surface, and a cathode of electric terminal on the upper surface. The position of photodiode 20 is precisely determined for making the optical receiver 22 receive light from the opening portion 31. The photodiode 20 is connected to the first conductive plate 30a through the connector 21.

The amplifier IC 61 includes an input terminal, an output terminal, a high-side power supply terminal, and a low-side power supply terminal that are arranged on the upper surface thereof, and includes no electric terminal arranged on the lower surface thereof. The lower surface of amplifier IC 61 is fixed to the first conductive plate 30a with soft solder, conductive adhesive or the like. The amplifier IC 61 can be arranged anywhere on the first conductive plate 30a, and precise positioning is not required for the amplifier IC 61. The capacitor 62 is arranged to cross over the first conductive plate 30a and second conductive plate 30b. The electric terminal at one end of capacitor 62 is connected to the first conductive plate 30a and the other electric terminal at the other end of capacitor 62 is connected to the second conductive plate 30b.

The high-side power supply terminal arranged on the upper surface of amplifier IC 61 is connected to the second conductive plate 30b through the wire 63. The input terminal of amplifier IC 61 is connected through the wire 64 to the cathode of electric terminal arranged on the upper surface of photodiode 20. The low-side power supply terminal of amplifier IC 61 is connected to the first conductive plate 30a through the wire 64. The output terminal of amplifier IC 61 is connected to the third conductive plate 30c through the wire 66. Thus, it is possible to implement the circuit shown in FIG. 18C. Therefore, it is possible to convert the optical signal received by the OSA 1 into the electrical signal and output the electrical signal from the third conductive plate 30c, because, for example, the first conductive plate 30a is connected to the ground potential while the second conductive plate 30b is connected to the power supply potential.

As described above, the OSA 1 may become one package that is sealing the photoelectric conversion device (photodiode 20 and the like) together with components of the peripheral circuit. It should be noted that the present invention is not limited to the examples of electrical circuit components and electrical circuits shown in FIGs. 18A-18C. The OSA 1 may include various different components and electrical circuits.

### (Embodiment 2)

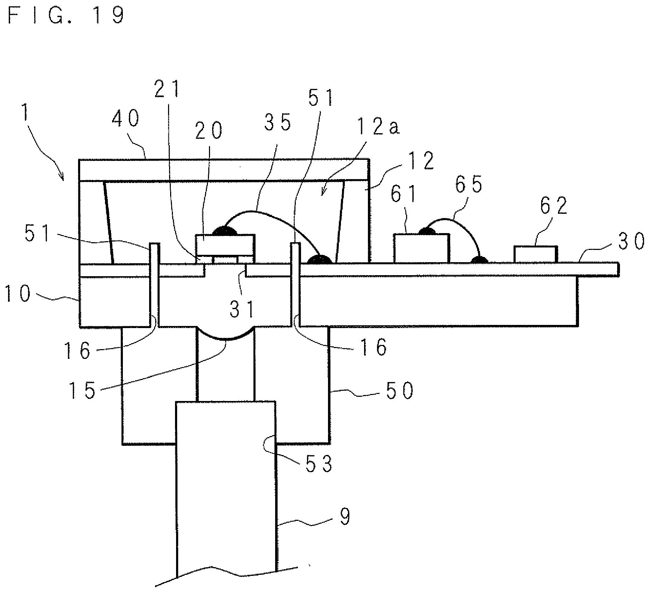

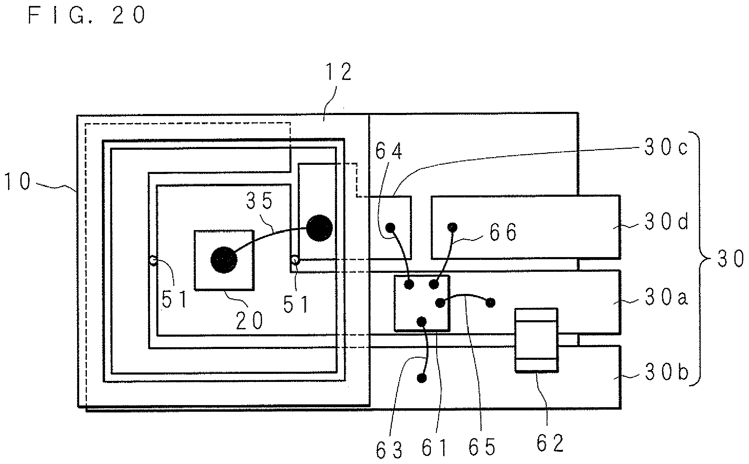

FIG. 19 is a schematic cross section view showing a configuration of optical communication module in Embodiment 2 according to the present invention. FIG. 20 is a schematic flat view showing a configuration of optical communication module without the cover 40 in the Embodiment 2 according to the present invention.

The numeral "1" represents the OSA corresponding to the optical communication module according to the present invention, which contains the sealed photodiode (photoelectric conversion device) 20 and the electrical circuit configured with the amplifier IC 61, capacitor 62 and the like. The OSA 1 is connected to the optical fiber (communication line) 9, and is utilized to perform optical communication for making the photodiode 20 receive light emitted through the optical fiber 9 by another device, for converting an optical signal into an electrical signal and for outputting the electrical signal.

The OSA 1 includes the basement (transparency maintaining unit) 10 that is formed in a substantial rectangular plate shape in a plain view, the photodiode 20 is connected to one surface of basement 10 (the surface at the upper side in FIG. 19; simply called "upper surface" hereinafter), and the cylindrical portion 50 is arranged on the other surface (the surface at the lower side in FIG. 19; simply called "lower surface" hereinafter) for connecting the optical fiber 9. The peripheral wall 12 is arranged to protrude horizontally near one side in the longitudinal direction and on the upper surface of basement 10, and is formed in a substantially-square shape in a plain view. The recess portion 12a is formed with the upper surface and peripheral wall 12 of basement 10, to accommodate the photodiode 20.

The conductive plate 30 made of metal is buried in the basement 10 of OSA 1, but one surface of conductive plate 30 is exposed from the upper surface of basement 10. The connector 21 of photodiode 20 is connected with soft solder, conductive adhesive or the like to the portion of conductive plate 30 exposed within the recess portion 12a, and/or the electric terminal of photodiode 20 arranged on the upper surface or the like is connected with the wire 35 to the portion of conductive plate 30 exposed within the recess portion 12a. In addition, the electrical circuit components (such as the amplifier IC 61 and capacitor 62) are connected directly with the soft solder, conductive adhesive or the like and/or through a wire to the portion of conductive plate 30 exposed outside the recess portion 12a. The conductive plate 30 is utilized for transmitting an electrical signal between the photodiode 20 and electrical circuit component, and for transmitting an electrical signal to/from the outside of OSA 1. In other words, the conductive plate 30 serves as the wiring that connects the components with each other in the reception circuit including the photodiode 20.

The OSA 1 in the Embodiment 2 includes four conductive plates 30a-30d (see FIG. 20). The first conductive plate 30a includes a substantially-square portion that is located at the center of recess portion 12a on the basement 10, and an extension portion that is in contact with the substantially-square portion and is extending in the longitudinal direction of basement 10 from the side surface of basement 10 to the outside of the basement 10. The opening portion 31 is formed as the optical pass portion at the substantial center of the substantially-square portion, for passing light. The opening portion 31 is configured to be located at the substantial center of recess portion 12a on the basement 10 in a plain view, after the first conductive plate 30a is fixed to the basement 10. The diameter of opening portion 31 is shorter than one side of lower surface of the photodiode 20, and longer than the diameter of optical receiver 22 included in the photodiode 20. The connector 21 of photodiode 20 is connected to the periphery of opening portion 31 in the first conductive plate 30 with the soft soldier or conductive adhesive. In addition, the amplifier IC 61 is fixed with adhesive or the like to the portion of first conductive plate 30a exposed outside the recess portion 12a. The amplifier IC 61 includes four electric terminals, and one of the electric terminals is connected through the wire 65 to the first conductive plate 30a.

The second conductive plate 30b is arranged to surround the first conductive plate 30a, and the one end portion is extending from the side surface of basement 10 to the outside. The capacitor 62 is an electrical circuit component including two electric terminals, one of which is connected to the first conductive plate 30a and the other of which is connected to the second conductive plate 30b. The second conductive plate 30b is connected through the wire 63 to the electric terminal arranged on the upper surface of amplifier IC 61.

The third conductive plate 30c is formed in a substantially-"L" shape, and is aligned in parallel with the first conductive plate 30a. One end portion of third conductive plate 30c is exposed outside the recess portion 12a on the basement 10, and the other end portion is exposed inside the recess portion 12a. The third conductive plate 30c is connected through the wire 35 to the electric terminal arranged on the upper surface of photodiode 20 inside the recess portion 12a, and connected with the wire 64 to the electric terminal arranged on the upper surface of amplifier IC 61 outside the recess portion 12a.

The fourth conductive plate 30d is formed in a substantially-rectangular shape, and is aligned in parallel with the conductive plate 30c in the longitudinal direction of basement 10. One end portion of fourth conductive plate 30d is exposed from the side surface of basement 10 to the outside. The fourth conductive plate 30d is connected through the wire 66 to the electric terminal arranged on the upper surface of amplifier IC 61. The extension portions of conductive plates 30a, 30b, 30d extending from the side surface of basement 10 are utilized as electric terminals for connecting the OSA 1, for example, to the circuit board of communication apparatus.

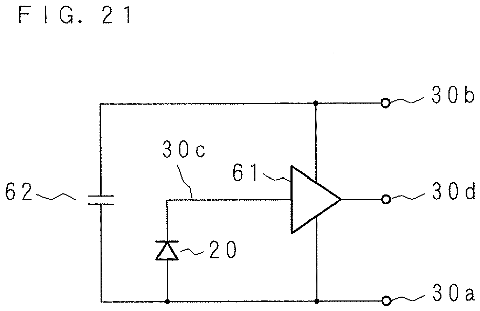

FIG. 21 is a circuit diagram showing an example of a reception circuit configured with the conductive plates 30a-30d of OSA 1. The OSA 1 in the Embodiment 2 includes the circuit receiving the optical signal because containing the photodiode 20 and another electrical circuit component (the amplifier IC 61 and capacitor 62) that are properly connected to the conductive plates 30a-30d. The photodiode 20 includes an anode of electric terminal (connector 21) on the lower surface, and a cathode of electric terminal on the upper surface. The position of photodiode 20 is precisely determined to make the optical receiver 22 receive light from the opening portion 31, and is connected to the first conductive plate 30a through the connector 21.

The amplifier IC 61 includes four electric terminals (input terminal, output terminal, high-side power supply terminal, and low-side power supply terminal) on the upper surface, but no electric terminal on the lower surface. The lower surface of amplifier IC 61 is fixed to the first conductive plate 30a with soft soldier, conductive adhesive or the like. The high-side power supply terminal arranged on the upper surface of amplifier IC 61 is connected through the wire 63 to the second conductive plate 30b. The input terminal of amplifier IC 61 is connected through the wire 64 to the third conductive plate 30c, i.e., electrically connected to the cathode of electric terminal included in the photodiode 20. The low-side power supply terminal of amplifier IC 61 is connected through the wire 65 to the first conductive plate 30a. The output terminal of amplifier IC 61 is connected through the wire 66 to the fourth conductive plate 30d.

As described above, the capacitor 62 is arranged to cross over the first conductive plate 30a and second conductive plate 30b. The electric terminal at the one end of capacitor 62 is connected to the first conductive plate 30a and the other electric terminal at the other end of capacitor 62 is connected to the second conductive plate 30b. Thus, it is possible to configure the electrical circuit shown in FIG. 21. Therefore, it is possible to convert the optical signal received by the OSA 1 into the electrical signal and to output the electrical signal from the fourth conductive plate 30d, for example, because the first conductive plate 30a is connected to the ground potential and the second conductive plate 30b is connected to the power supply potential.

In addition, the basement 10 and peripheral wall 12 of OSA 1 are integrally formed using a transparent synthetic resin. For example, it is possible for forming the integral unit to utilize so-called injection molding, in which the conductive plate 30 is previously formed in an arbitrary shape and put into the mold and the liquid transparent resin is poured and allowed to cure. In the case that the basement 10 is formed with the transparent synthetic resin, the photodiode 20 connected to the conductive plate 30 can receive light from the outside through the transparent basement 10 and the opening portion 31 of conductive plate 30. The synthetic resin utilized for configuring the basement 10 and peripheral wall 12 can be selected regardless of heat resistance of photodiode 20 and the like. Therefore, it is possible to select the synthetic resin that has a precise molding ability and tight tolerance to environment change, such as temperature change.

In addition, the convex lens 15 is arranged on the lower surface of basement 10. The lens 15 is integrally formed with the basement 10 by the transparent synthetic resin. The lens 15 is arranged on the lower surface of basement 10 at the position opposite to the opening portion 31 of conductive plate 30 fixed to the upper surface of basement 10. In other words, the center of lens 15 approximately matches to the center of opening portion 31. Therefore, the lens 15 can collect the light from the lower surface side of basement 10 and the optical receiver 22 of photodiode 20 can receive the collected light through the transparent basement 10 and the opening portion 31 of conductive plate 30. In other words, the portion between the lens 15 and the photodiode 20 connected to the conductive plate 30 of basement 10 works as the transparent portion for passing the outside light into the optical receiver 22 of photodiode 20 through the opening portion formed on the conductive plate 30. The diameter of lens 15 is larger than the diameter of optical receiver 22 included in the photodiode 20, and larger than the opening portion 31 of conductive plate 30.

In addition, the OSA 1 includes the cylindrical portion 50 that is formed in a cylindrical shape and protrudes from the lower surface of basement 10. The cylindrical portion 50 is formed independently from the basement 10, and connected to the lower surface of basement 10 to surround the lens 15 arranged on the lower surface of basement 10. The cylindrical portion 50 includes the lower side section whose inner diameter is enlarged stepwisely, i.e., in which the inner diameter of upper section is smaller than the inner diameter of lower section. The upper section includes the smaller inner diameter that is equal to or a little larger than the diameter of lens 15, and the lower section includes the larger inner diameter that is substantially equal to the diameter of optical fiber 9 and includes a fitting portion 53 for fitting the optical fiber 9 therein.

Plural and round rod-like connection pins 51 are arranged on the upper surface of cylindrical portion 50. The plural connection pins 51 are arranged to be equally spaced away from each other in the circumferential direction for the end surface of cylindrical portion 50. Plural connection holes 16 are arranged to vertically penetrate the basement 10, in which the connection pins 51 are inserted for supporting the cylindrical portion 50. The position of connection pin 51 in the cylindrical portion 50 and the position of connection hole 16 in the basement 10 are precisely determined to match the center of cylindrical portion 50 to the center of lens 15 when the connection pins 51 are inserted into the connection holes 16 and the cylindrical portion 50 is connected to the basement 10. The cylindrical portion 50 may be made of synthetic resin, or other materials such as metal or wood. Although the cylindrical portion 50 is connected by the connection pins 51 inserted into the connection holes 16 of the basement 10, an adhesive may additionally be utilized for stronger connection of the cylindrical portion 50.

The connection pin 51 of cylindrical portion 50 is longer than the depth of connection hole 16 in the basement 10. The upper end of connection pin 51 protrudes from the upper surface of basement 10 when the connection pin 51 is inserted into the connection hole 16 and the cylindrical portion 50 is connected to the lower surface of basement 10. Because the basement 10 can be precisely formed with the injection molding method and the like and precisely include the connection hole 16, it is possible to implement the precise positioning of connection pin 51 protruding from the connection hole 16. Therefore, it is possible to determine the position of photodiode 20 in reference to the protruding position of connection pin 51, to connect the photodiode 20 with the conductive plate 30.Thus, the center of optical receiver 22 in the photodiode 20 can precisely match to the center of lens 15.

Because the position of connection pin 51 and the position of connection hole 16 are precisely determined, the center of cylindrical portion 50 matches to the center of lens 15 when the connection pin 51 is inserted into the connection hole 16 and the cylindrical portion 50 is connected to the lower surface of basement 10. Furthermore, the center of cylindrical portion 50 matches to the center of lens 15 when the optical fiber 9 is fit to the fitting portion 53 of cylindrical portion 50, because the fitting portion 53 of cylindrical portion 50 is precisely formed. Therefore, it is possible to substantially match the center of lens 15 with the center of optical fiber 9. Moreover, it is possible to substantially match the center of optical receiver in the photodiode 20, with the center of lens 15 and with the center of optical fiber 9, and possible to make the photodiode 20 sensitively receive the light emitted from the optical fiber 9, because the photodiode 20 is connected to the conductive plate 30 to match the center of optical receiver 22 in the photodiode 20 with the center of lens 15.

The OSA 1 includes the cover 40, for sealing the recess portion 12a, which is attached to the upper end of peripheral wall 12 arranged on the upper surface side of basement 10. The plain view of cover 40 is a substantially-square plate shape, similar to peripheral wall 12, and the cover 40 is connected to the upper end of peripheral wall 12 with a connecting method, for example, utilizing ultrasonic welding or adhesive. The cover 40 may be transparent or non-transparent, and may be made of a material as same as or different from the basement 10, peripheral wall 12 and the like. Nitrogen gas or dry air may be applied into the recess portion 12a when the cover 40 is attached, or alternatively, the recess portion 12a is made vacuum.

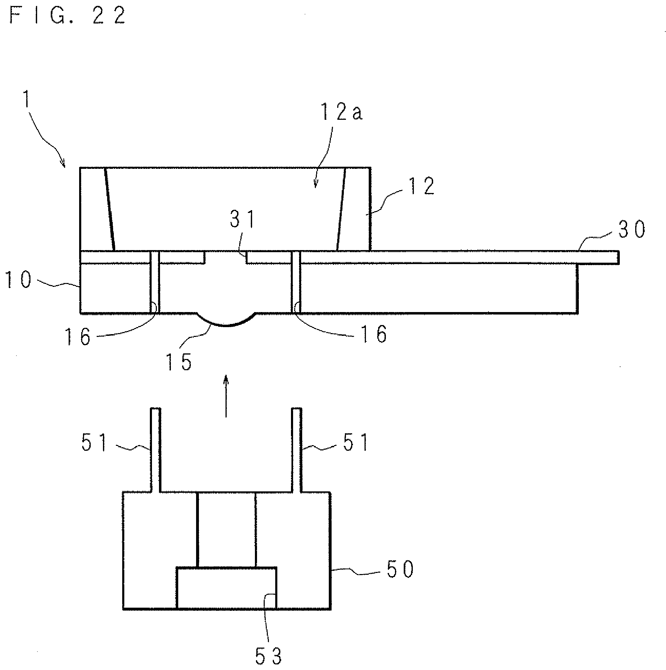

FIG. 22 to FIG. 26 are schematic views explaining a method for manufacturing the optical communication module in the Embodiment 2 according to the present invention. The manufacturing process of OSA 1 is illustrated in time-series figures from FIG. 22 to FIG. 26. In the manufacturing process of OSA 1 according to the present invention, the conductive plate 30 is formed in an arbitrary shape, for example, by machining a metal plate, the formed conductive plate 30 is put into the mold for the injection molding, liquid transparent resin is poured into the mold and is allowed to cure, and thus, the basement 10, peripheral wall 12, lens 15 and the like are formed integrally (this processing is not shown in figures). This processing allows the center of lens 15 to precisely match to the center of opening portion 31 in the conductive plate 30 arranged on the basement 10, and the relative position of connection hole 16 to these centers is precisely configured. In addition, the cover 40 and cylindrical portion 50 are previously formed with a method, such as resin molding.

Then, the cylindrical portion 50 formed separately and previously is connected to the lower surface of basement 10. The connection of cylindrical portion 50 can be implemented only with the connection pin 51 that is arranged on the upper surface of cylindrical portion 50 and is inserted into the connection hole 16 in the basement 10. It is not required to determine the position of cylindrical portion 50 with respect to the basement 10. The connection pin 51 may be inserted into the connection hole 16 to fix the cylindrical portion 50 to the basement 10, after adhesive is applied to the connection pin 51, connection hole 16, the upper surface of cylindrical portion 50, the lower surface of basement 10 and the like.

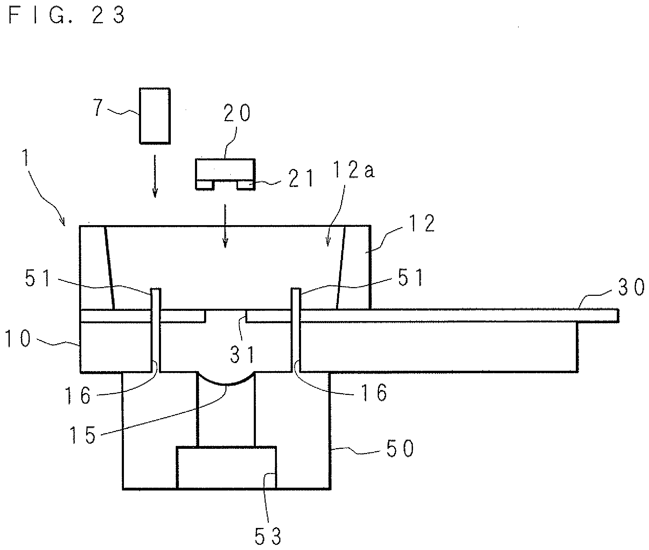

Then, for example, the camera 7 is utilized to capture the image from the upper surface side of basement 10 for recognizing the position of connection pin 51 protruding from the upper surface of basement 10 through the connection hole 16. The position of photodiode 20 is determined to be a predetermined position based on the recognized reference position, and the electric terminal portion 21 of photodiode 20 is connected to the conductive plate 30 (see FIG. 23). Therefore, the center of optical receiver 22 in the photodiode 20 precisely matches to the center of lens 15 and the center of cylindrical portion 50.

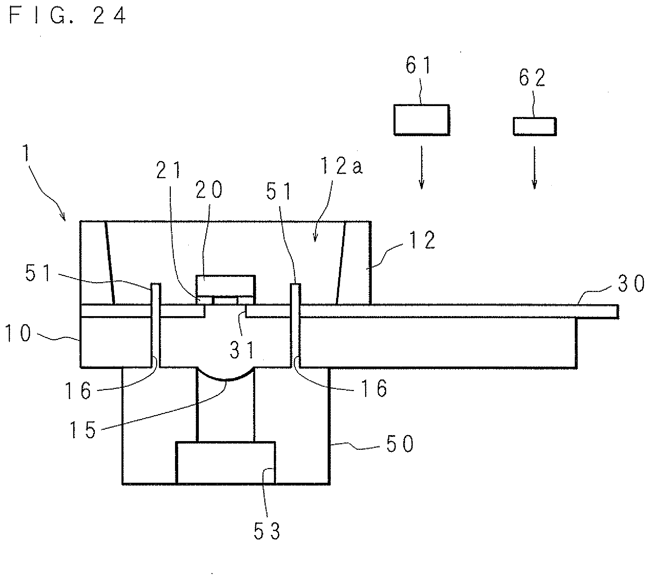

Then, electrical circuit components, such as the amplifier IC 61 and capacitor 62, are mounted on the region of conductive plate 30 that is exposed to the upper surface of basement 10 and is outside the recess portion 12a (See FIG. 24). Soft solder, conductive adhesive or the like may be utilized for connecting the electric terminal of electrical circuit component to the conductive plate 30. Non-conductive adhesive may be utilized for connecting a part other than the electrical terminal (such as a case for the electrical circuit component) to the conductive plate 30.

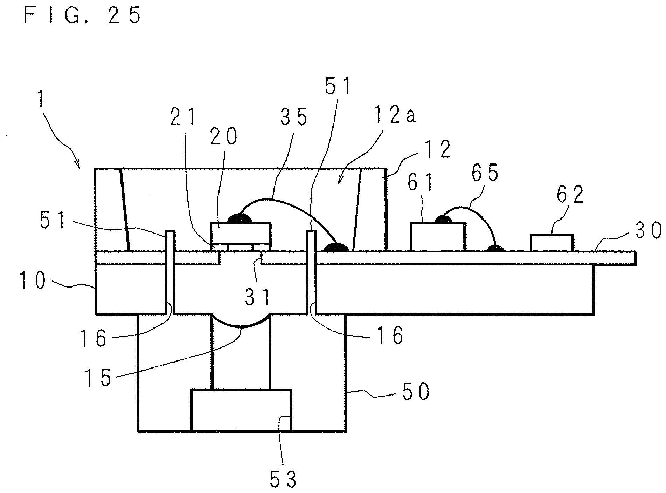

Then, wire 35 is utilized to connect the electric terminal arranged on the upper surface of photodiode 20 and the conductive plate 30c arranged on the basement 10, and wires 63-66 are utilized to connect four electric terminals arranged on the upper surface of amplifier IC 61 and the conductive plates 30a-30d arranged on the basement 10 (see FIG. 25). Thus, the photodiode 20, amplifier IC 61 and capacitor 62 are electrically connected as shown in the circuit diagram of FIG. 4. The communication apparatus including the OSA 1 can receive the optical signal based on the signals output from the fourth conductive plate 30d, as the first conductive plate 30a is connected to the ground potential and the second conductive plate 30b is connected to the power supply potential.

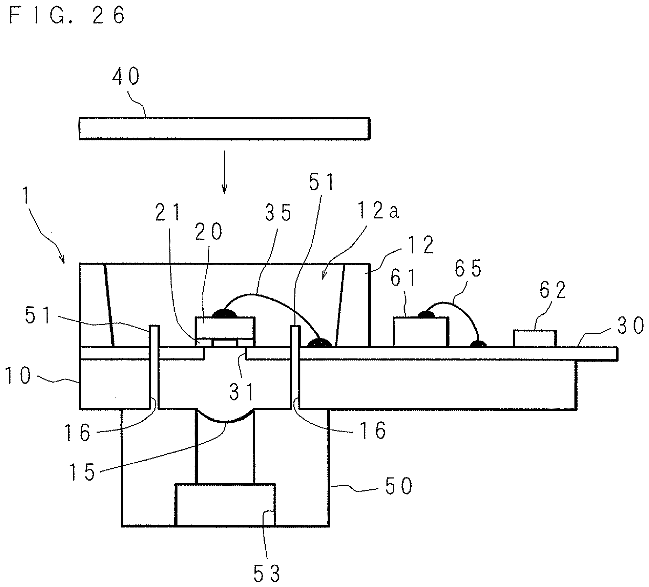

Then, the cover 40 is attached to the upper end of peripheral wall 12 with a connecting method, for example, utilizing ultrasonic welding or adhesive to seal the recess portion 12a that contains the photodiode 20 (See FIG. 26). Thus, the photodiode 20 is isolated from the outside. Gas may be injected into the recess portion 12a before the cover 40 is connected to the peripheral wall 12.

As described above, the OSA 1 includes the photodiode 20 arranged inside the recess portion 12a of basement 10, the electrical circuit components (such as the amplifier IC 61 and capacitor 62) arranged outside the recess portion 12a, and plural conductive plates 30a-30d and wires 35, 63-66 that are utilized for connecting the photodiode 20 and electrical circuit components. Therefore, OSA 1 can include plural electrical circuit components, without the need for the circuit board and the like, and the OSA 1 can utilize these electrical components to include the reception circuit and the like. The configurations of present invention can reduce the size of optical communication module including the electrical circuits (such as the reception circuit), greater than the optical communication module including the circuit board for the reception circuit. Furthermore, the configurations of present invention can reduce the number of parts because it is not required to include the circuit board and the peripheral parts for the circuit board. Therefore, it is possible to reduce the size of a communication apparatus and the like including the OSA 1 according to the present invention, to simplify the process for manufacturing the OSA 1, and to reduce the cost of OSA 1.

The position of photodiode 20 is determined to connect the photodiode 20 to the conductive plate 30 exposed inside the recess portion 12a of basement 10, and to perform the transmission of optical signals through the opening portion 31 of conductive plate 30 and the transparent basement 10. The cover 40 is utilized for sealing after the photodiode 20 is connected. Hence, the position of photodiode 20 in the OSA 1 can be precisely adjusted after the basement 10 is formed, and then the photodiode 20 can be connected to the conductive plate 30. Therefore, the sealing with the cover 40 does not affect the connection position of photodiode 20. It is thus possible to precisely form the basement 10 because the synthetic resin utilized for forming the basement 10 can be selected without considering the heat resistance ability of photodiode 20 and the like. Furthermore, it is possible to precisely adjust the positions of lens 15, optical fiber 9 and the like, because the position of photodiode 20 can be precisely determined in accordance with the basement 10 that is precisely formed. Hence, it is possible to enhance the optical communication performance of the OSA 1.

In addition, it is not required to implement precise connection of cover 40, because the photodiode 20 is sealed by the cover 40 connected to the recess portion 12a. Therefore, the photodiode 20 can be sealed with a simple method and low cost. In addition, the connection hole 16 into which the connection pin 51 is inserted is precisely formed together with the basement 10, the connection pin 51 of cylindrical portion 50 is arranged to protrude on the upper surface of basement 10 and the position of photodiode 20 is determined in reference to the connection pin 51. Therefore, it is possible to easily and precisely connect the photodiode 20 to the conductive plate 30 in reference to the connection pin 51.

In addition, the cylindrical portion 50 can be precisely connected to the basement 10 with the connection pin 51 and connection hole 16, because the cylindrical portion 50 is arranged on the lower surface of basement 10 to surround the lens 15 and the optical fiber 9 is fitted to the fitting portion 53 of cylindrical portion 50. Hence, it is possible to easily and precisely determine the positions of lens 15 and optical fiber 9. Furthermore, the light emitted from the optical fiber 9 can be collected by the lens 15 and surely detected by the photodiode 20. Therefore, it is possible to enhance the performance of optical communication by utilizing the OSA 1.

Although the OSA 1 in this Embodiment is illustrated to include the photodiode 20 as the photoelectric conversion device for receiving light, the present invention is not limited to this illustration. The OSA 1 in this Embodiment may include the laser diode as the photoelectric conversion device for emitting light. In addition, although the OSA 1 in this Embodiment is illustrated to include one photoelectric conversion device in the recess portion 12a, the present invention is not limited to this illustration. The OSA 1 in this Embodiment may include plural photoelectric conversion devices. In the case that two photoelectric conversion devices (photodiode and laser diode) are included, the OSA can emit and receive light and can perform the transmission of the optical signal.

In addition, the conductive plate 30 (30a-30d) shown in FIG. 20 is an example, and the present invention is not limited to this example. The circuit configuration shown in FIG. 21 is an example, and the present invention is not limited to this example. The electrical circuit components included in the OSA 1 are not limited to the amplifier IC 61 and capacitor 62. The other electrical circuit components may be included and various electrical circuits can be configured.

In addition, it is illustrated that the center of opening portion 31 in the conductive plate 30 approximately matches to the center of optical receiver 22 in the photodiode 20. However, it is not necessary for the center of optical receiver 22 to match with the center of opening portion 31 in the case that the center of optical receiver 22 substantially matches to the center of lens 15. In addition, although it is illustrated to utilize the wire 35 for connecting the electric terminal arranged on the upper surface of photodiode 20 and the conductive plate 30, the present invention is not limited to the illustration. The connection without the wire 35 may be employed, in the case that plural connectors 21 are arranged on the lower surface of photodiode 20.

Although the conductive plate 30 is illustrated to include the opening portion 31 as the optical pass portion and the optical receiver 22 of photodiode 20 is illustrated to receive light through the opening portion 31, the present invention is not limited to the illustration. For example, a notch, groove or the like may be formed as the optical pass portion on the conductive plate 30 for receiving light. For example, a gap between conductive plates 30 may be utilized as the optical pass portion through which the optical receiver 22 of photodiode 20 receives light. For example, in the case that the transparent electric conductor can be utilized for forming a part or all of the conductive plate 30, this transparent portion may be utilized as the optical pass portion for passing the light to the photodiode 20.

In addition, although the position of photodiode 20 is illustrated to be determined in reference to the connection pin 51 protruding on the upper surface of basement 10, the present invention is not limited to the illustration. Another method may be utilized for determining the position of photodiode 20.

### (Variation 1)

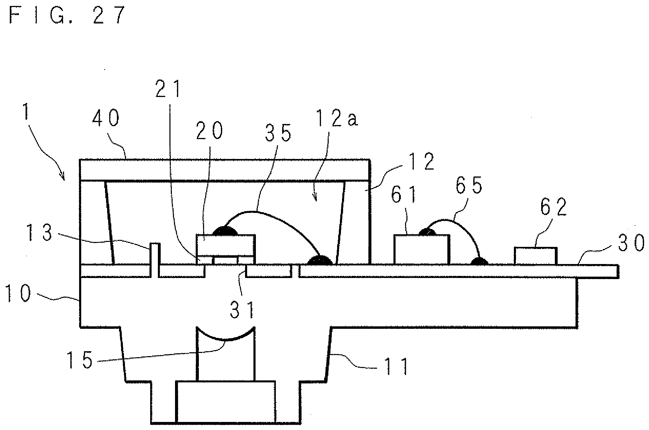

Although it is illustrated that the cylindrical portion 50 is formed separately and the connection pin 51 is inserted into the connection hole 16 for connecting the cylindrical portion 50 to the basement 10, the present invention is not limited to the illustration. The cylindrical portion may be formed integrally with the basement 10. FIG. 27 is a schematic cross section view showing a configuration of the optical communication module in Variation 1 of Embodiment 2 according to the present invention. The OSA 1 in this Variation 1 includes the cylindrical portion 11 protruding on the lower surface of basement 10 and surrounding the lens 15. This cylindrical portion 11 is made of transparent synthetic resin and formed integrally with the basement 10. The center of cylindrical portion 11 substantially matches to the center of lens 15.

The round rod-shaped positioning unit 13 is arranged to protrude inside the recess portion 12a on the upper surface of basement 10. The positioning unit 13 is utilized as the reference position for determining the position of photodiode 20 when the photodiode 20 is connected to the conductive plate 30 in the recess portion 12a. The position of positioning unit 13 to the center of opening portion 31 in the conductive plate 30 on the basement 10 or to the center of lens 15 is precisely determined. The manufacturing machine for connecting the photodiode 20 to the conductive plate 30 may connect the photodiode 20 at the position separated from the positioning unit 13 by a predetermined distance in a predetermined direction, for example, in reference to the position of positioning unit 13 recognized by the image captured from the upper surface of basement 10 by the camera.

Thus, it is not required to perform a process of connecting the separated cylindrical portion 50 to the basement 10 in the process manufacturing the OSA 1. Therefore, it is possible to simplify the manufacturing process. Furthermore, the cylindrical portion 11 can be precisely formed integrally with the basement 10. Therefore, it is possible to precisely match the center of lens 15 to the center of optical fiber 9 when the optical fiber 9 is connected to the cylindrical portion 11.

### (Variation 2)

In the method of manufacturing the optical communication module described above, the photodiode 20 is connected to the conductive plate 30 inside the recess portion 12a (see FIG. 23) and then the electrical circuit components such as the amplifier IC 61 and capacitor 62 are connected to the conductive plate 30 outside the recess portion 12a with soft solder, conductive adhesive or the like (see FIG. 24), as shown in FIG 22 to FIG. 26. However, the present invention is not limited to such an embodiment. In the method of manufacturing the optical communication module in a Variation 2, the photodiode 20 is connected to the conductive plate 30 inside the recess portion 12a, and then the cover 40 is attached to the peripheral wall 12 without connecting the electrical circuit components to the conductive plate 30 outside the recess portion 12a.

After the cover 40 is attached, the electrical circuit component is connected to the conductive plate 30 outside the recess portion 12a. At that time, the electrical circuit component is connected with the solder reflow method, i.e., printing solder including flux onto the conductive plate 30; arranging the electrical circuit components on the solder; and sweating the solder.

In the case where the wire bonding is performed with the wire 35 on the photodiode 20, the flux utilized in the solder reflow method is not preferred for the photodiode 20. However, recess portion 12a is sealed with cover 40 in the manufacturing method of Variation 2, thus the electrical circuit components can be connected to the conductive plate 30 outside the recess portion 12a with the solder reflow method.

### (Embodiment 3)

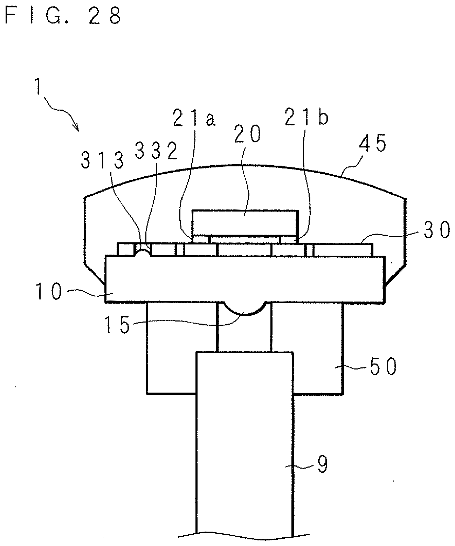

The OSA 1 in Embodiment 3 is configured to reduce the cost for plastic resin seal in the manufacturing process. FIG. 28 is a schematic cross section view showing a configuration of the optical communication module in the Embodiment 3 according to the present invention. The numeral "1" in figures represents the OSA in which the photodiode (photoelectric conversion device) 20 is packaged. The OSA 1 corresponds to an optical communication module according to the present invention. The optical fiber 9 is connected to the OSA 1. The OSA 1 is a device for utilizing the photodiode 20 to receive light emitted from another device through the optical fiber 9, converting an optical signal into an electrical signal and outputting the electrical signal to perform an optical communication.

The OSA 1 includes the plate-shaped basement (transparency maintaining unit) 10 that is approximately square in plain view. The metal conductive plate 30 is arranged on one surface of basement 10 (upper surface in FIG. 28; said one surface is simply called the "upper surface", hereinafter), while the photodiode 20 is connected to the conductive plate 30. The sealing unit 45 is also arranged on the upper surface, which seals the conductive plate 30 and photodiode 20 with the synthetic resin. In addition, the basement 10 is made of transparent resin. The lens 15 is integrally formed on the other surface of basement 10 (lower surface in FIG. 28; said other surface is simply called the "lower surface", hereinafter). The cylindrical portion 50 is arranged to protrude on the lower surface around the lens 15 for fitting the optical fiber 9 therein.

The photodiode 20 is approximately square shaped plate in a plain view. The optical receiver 22 is formed at the substantial center on the lower surface of photodiode 20, which converts an optical signal into an electrical signal in response to detection of light. One or more connectors are arranged around the optical receiver 22. The connector is an electric terminal for inputting and outputting the electrical signal of photodiode 20, and for connecting photodiode 20 to the conductive plate 30 with soft solder, conductive adhesive or the like.

It is described below in the context of OSA 1 including the photodiode 20 in which two connectors 21a, 21b are arranged on the lower surface as shown in FIG. 2B. However, the photodiode 20 included in the OSA 1 may alternatively be configured as shown in FIG. 2A or FIG. 2C, or may have other configurations.

The metal conductive plate 30 is arranged on the basement 10 of OSA 1. The conductive plate 30 is formed in an arbitrary pattern, for example, by cutting or etching the metal plate. The connectors 21a, 21b of photodiode 20 are connected to the upper surface of conductive plate 30 with soft solder, conductive adhesive or the like, and the lower surface of conductive plate 30 touches the upper surface of basement 10. The conductive plate 30 is utilized for performing the transmission of electrical signals between the photodiode 20 and the outside, and corresponds to the wiring connecting the circuit components in the reception circuit including the photodiode 20.

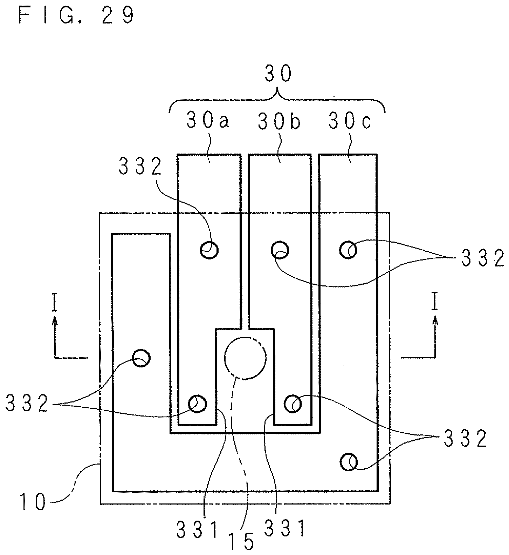

FIG. 29 is a schematic flat view showing a configuration of conductive plate 30 included by the optical communication module of Embodiment 3 according to the present invention. FIG. 29 shows the outline of basement 10 illustrated by the two-dot chain line which is overlaid on the upper surface of conductive plate 30. In the illustrated example, the OSA 1 includes three conductive plates 30a-30c. The first conductive plate 30a and second conductive plate 30b are connected to the connectors 21a, 21b of photodiode 20, respectively. Each of the first conductive plate 30a and second conductive plate 30b is configured in a substantial rectangular shape in a plain view, whose one end in the longitudinal direction is extending to the outside of basement 10 and the other end is positioned at the center of basement 10. In addition, the lens 15 is arranged at the center of lower surface on the basement 10, and a notch 331 is formed on each of said other ends of first conductive plate 30a and second conductive plate 30b. The notch 331 is configured not to cover the region at the side opposite to the lens 15. In other words, the first conductive plate 30a and second conductive plate 30b are arranged to sandwich the lens 15 in a plain view, and the gap between the first conductive plate 30a and second conductive plate 30b caused by the notch 331 works as the optical pass portion for passing light to the upper and lower surface sides of conductive plate 30.

The third conductive plate 30c is formed in a substantially-"U" shape, and arranged along the periphery of basement 10 to surround the first conductive plate 30a and second conductive plate 30b. One end portion of third conductive plate 30c is extending to the outside of basement 10. The third conductive plate 30c is utilized for shielding the OSA 1 and is connected, for example, to the ground potential. The portions of conductive plates 30a-30c extending from the basement 10 are utilized as electric terminals connecting the OSA 1, for example, to the circuit board of a communication apparatus.

In addition, plural positioning holes 322 are respectively formed at proper positions on the conductive plate 30 (first conductive plate 30a-third conductive plate 30c). Each positioning hole 322 is formed in a substantially-circular shape, and penetrates the upper and lower surfaces of conductive plate 30. On the other hand, plural positioning projections 313 are formed on the upper surface of basement 10. Each positioning projection 313 is formed in a substantially-circular shape in a plain view, and is formed to have a size that can be put into the positioning hole 332 of conductive plate 30.

The position where each positioning projection 313 is formed on the upper surface of basement 10 is precisely determined to define the position for arranging the conductive plate 30. Therefore, the conductive plate 30 is precisely arranged as shown in FIG. 29 without adjusting the position of conductive plate 30, when the conductive plate 30 is put on the upper surface of basement 10 while the positioning hole 332 of conductive plate 30 fits to the positioning projection 313 of basement 10 in the process manufacturing the OSA 1.

The photodiode 20 is connected to the conductive plate 30 arranged on the upper surface of basement 10. The connection position of photodiode 20 may be determined in reference to the position of positioning projection 313 or conductive plate 30 arranged on the upper surface of basement 10, or may be determined in reference to a mark or the like put on the lower surface of basement 10 which can be recognized through the transparent basement 10 and lens 15.

When the OSA 1 described above has been actually created with the conductive plate 30 whose thickness is about 100 µm, width is not less than 200 µm and the distance between each of plural conductive plate 30 (30a-30c) is not less than 200 µm, the position of conductive plate 30 has been shifted with respect to the basement 10 by only + 50 µm or less. In addition, when the OSA 1 described above has been actually created with the photodiode 20 in which each side of connectors 21a, 21b is not less than 100 µm, the Variation in positional aberration for the photodiode 20 has been within ± 10 µm. Each of these values is an example, and it is possible to further enhance the ability of implementing the precise positioning of arranged conductive plate 30 and the precise positioning of connected photodiode 20.

The basement 10, positioning projection 313, lens 15 and the like of OSA 1 are formed integrally with transparent synthetic resin. For example, the integral formation can be performed, for example, by so-called injection molding method, i.e., pouring liquid transparent resin into the mold previously manufactured and allowing the resin to cure. Because the basement 10 is made of transparent synthetic resin, the photodiode 20 connected to the conductive plate 30 can receive light incident from the lens 15 through the transparent basement 10 and through the gap between the first conductive plate 30a and second conductive plate 30b. In addition, the synthetic resin used for forming the basement 10 can be selected regardless the heat resistance ability of photodiode 20 and the like. Therefore, it is possible to select the synthetic resin that has the high ability of precise forming and that shows high resistance to deformation in response to environment change, such as temperature change.

The conductive plate 30 arranged on the basement 10 and the photodiode 20 connected to conductive plate 30 are sealed with the synthetic resin. The sealing unit 45 is arranged on the upper surface of basement 10, which seals the photodiode 20 and conductive plate 30. The sealing unit 45 may be made of transparent or non-transparent synthetic resin different from the synthetic resin for basement 10. The synthetic resin of sealing unit 45 should be selected in consideration of heat resistance for the photodiode 20 and the like, although it is not required to have a precise forming ability.

The lens 15 is integrally formed at approximately the center on the lower surface of basement 10, and the lens 15 has a convex shape extending to the lower side. The lens 15 collects light coming from the lower side of basement 10, and directs the collected light toward the optical receiver 22 of photodiode 20 through the transparent basement 10. The position of photodiode 20 is determined on the conductive plate 30 to match the center of lens 15 with the center of optical receiver 22, and then the photodiode 20 is connected to the conductive plate 30.

The cylindrical portion 50 arranged on the lower surface of basement 50 is formed in a cylindrical shape, and is manufactured separately from the basement 10. The cylindrical portion 50 may be made of synthetic resin, metal or another material. The position of cylindrical portion 50 is determined such that the center of cylindrical portion 50 matches with the center of lens 50, and then the cylindrical portion 50 is connected to the lower surface of basement 10 with a connecting method, such as welding or using an adhesive. The cylindrical portion 50 has one inner diameter at the one side connected to the basement 10 (the upper side in FIG. 28) which is a little larger than the diameter of lens 15, and has the other inner diameter at the other side (the lower side in FIG. 28) which is larger than said one inner diameter. Thus, the optical fiber 9 for optical communication can be fit to the lower side of cylindrical portion 50. When the optical fiber 9 is fit to the cylindrical portion 50, the end surface of optical fiber 9 is opposed to the lens 15 and the center of optical fiber 9 substantially matches with the center of lens 15.

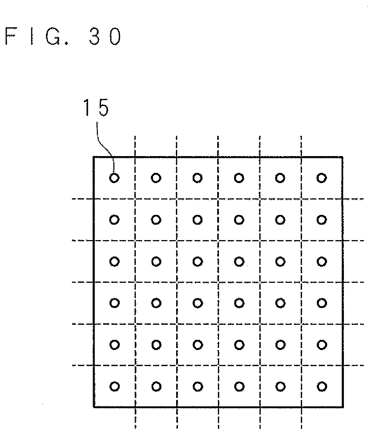

FIG. 30 to FIG. 35 are schematic views explaining a method for manufacturing the optical communication module in the Embodiment 3 according to the present invention. The manufacturing process of OSA 1 is illustrated in the time-series figures from FIG. 30 to FIG. 35. In the OSA 1 according to the present invention, the basement 10 can be manufactured separately from the conductive plate 30, cylindrical portion 50 and the like. Thus, plural basements 10 can be formed with the injection molding method at the same time in the manufacturing process. In the process of manufacturing the OSA 1 according to the present invention, the liquid transparent resin is firstly poured into a pre-manufactured mold (not shown in figures) and then is cured, for manufacturing a plate configured with plural basements 10 that are connected in 6 x 6 matrix arrangement (see FIG. 30). In this step, the lens 15 and projection 313 of each basement 10 are also formed.

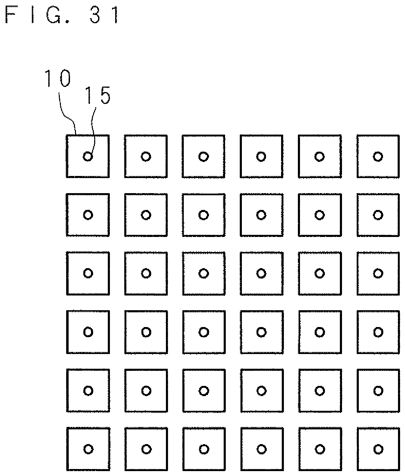

Then, dice cutting is performed on the plate configured with plural basements 10 connected in the matrix arrangement. For example, the plate can be cut on the broken lines shown in FIG. 30. The dice cutting of the plate generates thirty-six separated basements 10 (see FIG. 31). Precise cutting of basement 10 is not required in this step.

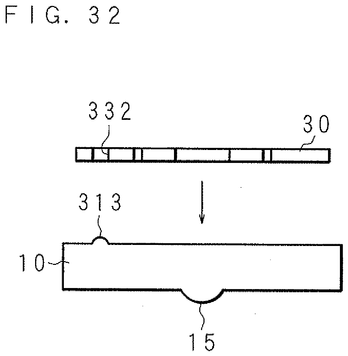

Then, the conductive plate 30 is arranged on the upper surface of the separated basement 10 (see FIG. 32). The conductive plate 30 is formed in an arbitrary shape from a metal plate on which dice cutting or etching is previously performed. When the conductive plate 30 is arranged on the upper surface of basement 10, the position of conductive plate 30 is determined to make the plural positioning holes 332 formed on the conductive plate 30 fit to the positioning projections 313 in the basement 10. Thus, the position of conductive plate 30 can be determined properly on the basement 10. The conductive plate 30 may be fixed with an adhesive or the like to the basement 10 in this step.

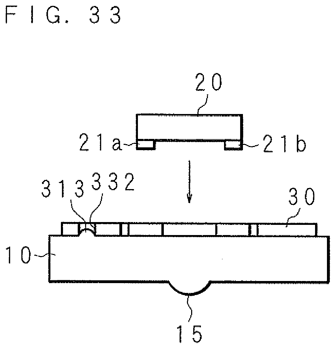

Then, the photodiode 20 is connected to the conductive plate 30 arranged on the basement 10 (see FIG. 33). At that time, the position of basement 10 is captured from the upper side by a camera and the like, to confirm the proper position of positioning projection 313 or conductive plate 30. In reference to the confirmed position, the position of photodiode 20 is determined, and then the connectors 21a, 21b of photodiode 20 are connected to the conductive plate 30 with the soft solder, conductive adhesive or the like. Thus, the center of optical receiver 22 in the photodiode 20 precisely matches to the center of lens 15 of the basement 10.

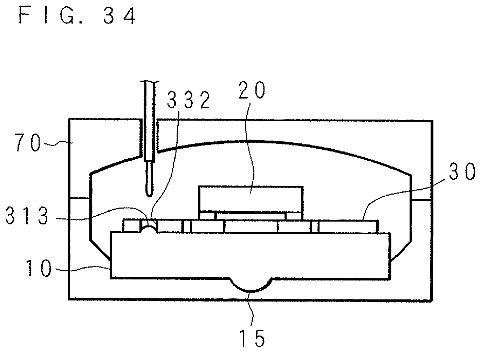

Then, the basement 10, photodiode 20 and conductive plate 30 are put into the pre-manufactured mold 70, and the liquid synthetic resin is poured into the mold 70 and cured, to form the sealing unit 45 (see FIG. 34). The formed sealing unit 45 may preferably be formed to cover the upper surface side of basement 10 and to prevent at least the photodiode 20 and conductive plate 30 from moving with respect to the basement 10. In the case that the conductive plate 30 is fixed to the basement 10 with adhesive or the like, the sealing unit 45 may cover only the photodiode 20.

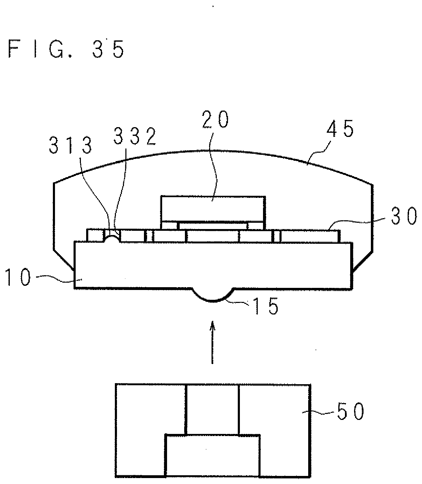

Then, the cylindrical portion 50 is fixed to the lower surface of basement 10 to manufacture the OSA 1 (see FIG. 35). When the cylindrical portion 50 is fixed, the position of cylindrical portion 50 is determined to match the center of cylindrical portion 50 with the center of lens 15 arranged on the lower surface of basement 10. The lower surface of basement 10 and upper surface of cylindrical portion 50 may be configured, for example, with a convex and concave portions similar to the positioning projection 313 of basement 10 and positioning hole 332 of conductive plate 30, for determining the position of cylindrical portion 50. This facilitates the positioning of cylindrical portion 50.

The OSA 1 described above includes: the conductive plate 30 arranged on the upper surface of transparent basement 10; the photodiode 20 connected to the conductive plate 30; and the sealing unit 45 sealing the photodiode 20 and conductive plate 30. Therefore, it is possible to separate the step for forming the basement 10 with resin from the step for arranging the conductive plate 30 and photodiode 20 on the basement 10. Hence, plural basements 10 can be integrally formed with transparent resin, and then separated into each basement 10. Therefore, it is possible to reduce the cost for manufacturing the basement 10, in comparison with the case that each basement 10 is formed with resin one by one.

In addition, it is possible to easily and precisely arrange the conductive plate 30 to each basement 10, because the positioning projection 313 is provided to the basement 10 and the positioning hole 332 is provided to the conductive plate 30 to determine the position of conductive plate 30 in reference to the basement 10 by fitting the positioning projection 313 into the positioning hole 332. In addition, it is possible to manufacture each basement 10 with resin indivisually as described above, because the lens 15 is formed integrally on the lower surface of basement 10 and the photodiode 20 is configured to perform the transmission of optical signal through the gap (optical pass portion) between the lens 15, basement 10 and conductive plate 30. Hence, it is possible to form the basement 10 with resin having a precise forming ability, regardless of the heat resistance and the like of photodiode 20. Therefore, it is possible to precisely form the lens 15 together with the basement 10, realizing highly precise OSA 1 to be formed at low cost.

Although the OSA 1 in this Embodiment is illustrated to include the photodiode 20 as the photoelectric conversion device for receiving light, the present invention is not limited to the illustration. The OSA 1 may alternatively be configured to include a laser diode like the vertical cavity surface emitting laser (VICSEL) as the photoelectric conversion device. In addition, although the OSA 1 is illustrated to include one photoelectric conversion device, the present invention is not limited to the illustration. The OSA 1 may alternatively be configured to include plural photoelectric conversion devices. In the case that the OSA 1 includes both the photodiode and laser diode as the photoelectric conversion device, the OSA 1 can emit and receive light and can perform the transmission of optical signals.

Although the photodiode 20 and conductive plate 30 are illustrated to be sealed with synthetic resin and to be fixed to the basement 10, the present invention is not limited to the illustration. The photodiode 20 and conductive plate 30 may be sealed and fixed by another method. In addition, the configuration of conductive plate 30 (30a-30c) shown in FIG. 29 is an example, and the present invention is not limited to this example. In addition, the conductive plate 30 is illustrated to include the positioning hole 332 penetrating the conductive plate 30, the present invention is not limited to the illustration. Alternatively, the conductive plate 30 may include a concave portion for the positional determination which does not penetrate the conductive plate 30.

### (Variation 1)

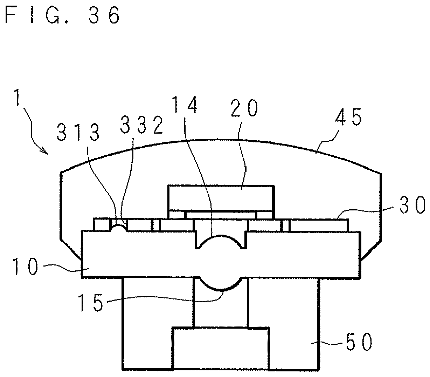

FIG. 36 is a schematic cross section view showing a configuration of optical communication module in a Variation 1 of Embodiment 3 according to the present invention. The OSA 1 according to the Variation 1 includes the lens 15 integrally formed on the lower surface of basement 10, and the lens 14 integrally formed on the upper surface of basement 10. The lens 14 on the upper surface is formed in a convex shape extending upward, and the center of lens 14 matches to the center of lens 15. The light emitted from the optical fiber 9 fit to the cylindrical portion 50 is input into the lens 15, passes through the basement 10, is output from the lens 14 and is received by the optical receiver 22 of photodiode 20.

At that time, the lens 15 can change the light coming from the optical fiber 9 to be approximately parallel with the optical axis of lens 15, the changed parallel light can pass through the basement 10, and the lens 14 can collect the passing light and can direct the light to the optical receiver 22 of photodiode 20. Even if the center of lens 14 does not match precisely to the center of lens 15, the precise adjustment of the positions of lens 14 and photodiode 20 can implement accurate collecting and directing of light from the lens 14 to the optical receiver 22 of photodiode 20, because the approximately-parallel light passes through the basement 10.

### (Variation 2)

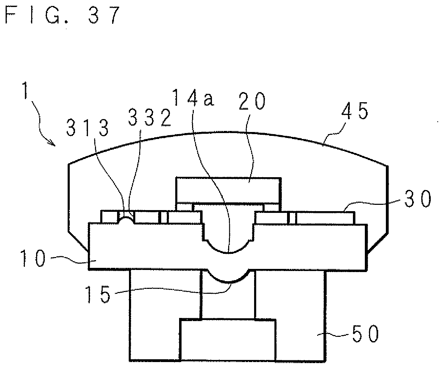

Although the OSA 1 in the Variation 1 described above is illustrated to include the lens 14 integrally formed on the upper surface of basement 10 in a convex shape extending upward, the present invention is not limited to the illustration. FIG. 37 is a schematic cross section view showing a configuration of optical communication module in Variation 2 of Embodiment 3 according to the present invention. The OSA 1 in the Variation 2 includes the lens 14a arranged on the upper surface of basement 10, and formed in a concave shape whose center is falling downward.

In the configuration that the synthetic resin flows into the gap between the optical receiver 22 of photodiode 20 and the lens 14a when the photodiode 20 is sealed with the synthetic resin and the sealing unit 45 is formed, it is required to form the sealing unit 45 with transparent synthetic resin. Depending on the refractive indices of transparent synthetic resin forming the lens 14a and of transparent synthetic resin forming the sealing unit 45, the concave lens 14a may be arranged on the upper surface of basement 10 instead of the convex lens 14. Alternatively, another lens having a more complex surface construction may be arranged on the upper surface of basement 10.

### (Variation 3)

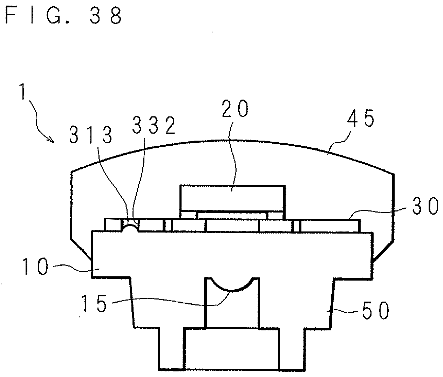

FIG. 38 is a schematic cross section view showing a configuration of optical communication module in Variation 3 of Embodiment 3 according to the present invention. Although the OSA 1 in the Embodiment described above includes separately-formed basement 10 and cylindrical portion 50 and the cylindrical portion 50 is fixed to the basement 10, the OSA 1 in the Variation 3 is configured to include the cylindrical portion 50 integrally formed with the basement 10. This configuration can simplify the manufacturing process of OSA 1 and reduce the manufacturing cost of OSA 1, because the cylindrical portion 50 can be manufactured together with the basement 10 when many basements 10 are integrally formed with resin (see Fig. 30). In addition, it is possible to precisely match the center of lens 15 to the center of optical fiber 9 fit to the cylindrical portion 50, because the cylindrical portion 50 can be formed precisely in reference to the lens 15. Therefore, it is possible to enhance the communication performance of OSA 1.

### EXPLANATION OF ITEM NUMBERS

1 OSA (optical communication module)
7 camera
8 holder
9 optical fiber
10 basement (transparency maintaining unit)
11 cylindrical portion
12 peripheral wall
12a recess portion
13 positioning unit
14, 14a lens
15 lens
16 connection hole
18 flat surface
20 photodiode (photoelectric conversion device)
21, 21a-21d connector
22 optical receiver (photoelectric conversion unit)
30, 30a-30d conductive plate (electric conductor)
31 opening portion (optical pass portion)
35 wire
37 terminal portion
40 cover (sealing means)
45, 461 sealing unit (sealing means)
50 cylindrical portion
51 connection pin
52 flat surface
61 amplifier IC (electrical circuit component)
62 capacitor (electrical circuit component)
63-66 wire
71 upper mold
72 lower mold
72a rod-like protrusion
80 cylindrical portion
81 recess portion
82 cut portion
83 fitting portion
84 through hole
313 positioning projection (projection)
331 notch
332 positioning hole (hole portion)

## Claims

1. An optical communication module, comprising:
(a) a photoelectric conversion device (20) that is provided with a photoelectric conversion unit (22) and a connector (21, 21a - 21d) on one surface of the photoelectric conversion device (20), wherein the photoelectric conversion unit (22) performs a photoelectric conversion from an optical signal to an electrical signal or from an electrical signal to an optical signal with receiving or emitting light, and the connector (21, 21a - 21d) connects the photoelectric conversion device (20) to another device;
(b) an electric conductor (30, 30a - 30d) that is connected to the connector (21, 21a - 21d) of the photoelectric conversion device (20) and is provided with an optical pass portion (31) that passes light toward the photoelectric conversion unit (22) of the connected photoelectric conversion device (20);
(c) a transparency maintaining unit (10) that comprises a transparent portion passing light between one side and another side, opposite to the one side, of the transparency maintaining unit (10) and that holds the electric conductor (30, 30a - 30d), wherein a portion connecting the photoelectric conversion device (20) is exposed at the one side;
(d) a sealing means (40, 45 46) for sealing the photoelectric conversion device (20) connected to the electric conductor (30, 30a - 30d), wherein
(e) the transparency maintaining unit (10) is provided with a recess portion (12a) that accommodates the photoelectric conversion device (20),
(f) the sealing means (40, 45, 46) is provided with a cover (40) that seals the recess portion (12a),
(g) the photoelectric conversion device (20) performs a transmission of an optical signal between the one side and the other side through the transparent portion of the transparency maintaining unit (10) and the optical pass portion (31) of the electric conductor (30, 30a - 30d), and
(h) a cylindrical portion (50) that protrudes at the the other side of the transparency maintaining unit (10) and internally fits a communication line for performing an optical communication, wherein:
(i) the cylindrical portion (50) comprises a cylindrical body and plural connection pins (51) protruding from the cylindrical body, and
(j) the transparency maintaining unit (10) comprises a plurality of connection holes (16) through which the connection pins (51) extend between its one side and its other side in such a way that tip portions thereof protrude from the one side of the transparency maintaining unit (10).

2. The optical communication module according to claim 1, further comprising one or more electrical circuit components (61, 62) that are connected to an exposure portion of the electric conductor (30, 30a - 30d) where the electric conductor (30, 30a - 30d) is exposed outside the recess portion (12a) of the transparency maintaining unit (10).

3. The optical communication module according to claim 2, further comprising another of the electric conductor (30, 30a - 30d), wherein the photoelectric conversion device (20) and the electrical circuit components (61, 62) are electrically connected through the electric conductors (30, 30a - 30d), to configure an electrical circuit for the photoelectric conversion.

4. The optical communication module according to claim 2 or 3, wherein the electrical circuit component is connected to the electric conductor (30, 30a - 30d) with a soft solder including a flux.

5. The optical communication module according to any one of claims 1 to 4, further comprising a lens (15) arranged at the other side of the transparency maintaining unit (10), wherein:
- the transparency maintaining unit (10) and the lens (15) are integrally formed with a transparent resin, and
- the photoelectric conversion device (20) performs transmission of an optical signal between the one side and the other side through the lens (15), the transparent portion of the transparency maintaining unit (10) and the optical pass portion (31) of the electric conductor (30, 30a - 30d).

6. The optical communication module according to any one of claims 1 to 5, further comprising a cylindrical portion (11) that protrudes at the other side of the transparency maintaining unit (10) and internally fits a communication line for performing an optical communication, wherein:
- the cylindrical portion (11) is formed integrally together with the transparency maintaining unit (10), and
- the photoelectric conversion device (20) performs the transmission of an optical signal between the one side and the other side through an internal area of the cylindrical portion (11), the transparent portion of the transparency maintaining unit (10) and the optical pass portion (31) of the electric conductor (30, 30a - 30d).

7. The optical communication module according to any one of claims 1 - 5, further comprising a cylindrical portion (80) that accommodates the transparency unit (10) at one side of the cylindrical portion and a communication line for the optical communication at the other side of the cylindrical portion, wherein:
- the electric conductor (30, 30a - 30d) is formed in a plate shape,
- the transparency maintaining unit (10) holds the electric conductor (30, 30a - 30d) whose end portion extends to outside,
- a surface at the one side of the cylindrical portion (80) is fixed to a portion of the electric conductor (30, 30a - 30d) extending from the transparency maintaining unit (10), and
- the photoelectric conversion device (20) performs the transmission of an optical signal between the one side and the other side through an internal area of the cylindrical portion, the transparent portion of the transparency maintaining unit (10) and the optical pass portion (31) of the electric conductor (30, 30a - 30d).

8. The optical communication module according to any one of claims 1-5, further comprising a cylindrical portion (50) that is fixed in contact with the other side of the transparency maintaining unit (10) and internally fits a communication line for the optical communication, wherein:
- contact portions of the transparency maintaining unit (10) and the cylindrical portion (50) are flat surfaces, and
- the photoelectric conversion device (20) performs the transmission of an optical signal between the one side and the other side through an internal area of the cylindrical portion (50), the transparent portion of the transparency maintaining unit (10) and the optical pass portion (31) of the electric conductor (30, 30a - 30d).

9. The optical communication module according to any one of claims 1-8, further comprising a positioning unit (13) that protrudes at the one side of the transparency maintaining unit (10) and defines a position for arranging the photoelectric conversion device (20).

10. The optical communication module according to any one of claims 1-8, further comprising a positioning pore that penetrates the one side and the other side of transparency maintaining unit (10) and defines a position for arranging the photoelectric conversion device (20), wherein:
- the transparency maintaining unit (10) is made of transparent resin with utilizing a mold for the one side and another mold for the other side, and
- the positioning pore is formed with the another mold for the other side of transparency maintaining unit (10).

11. The optical communication module according to any one of claims 1-10, wherein:
- the transparency maintaining unit (10) comprises a projection (313) that defines a position for holding the electric conductor (30, 30a - 30d), and
- the electric conductor (30, 30a - 30d) comprises a hole portion (332) or a concave portion that fits to the projection (313) of the transparency maintaining unit (10).

12. The optical communication module according to any one of claims 1-11, further comprising a wire (63 - 66) that electrically connects the electric conductor (30, 30a - 30d) to another surface of photoelectric conversion device (20) different from the one surface on which the photoelectric conversion unit (22) and the connector (21, 21a - 21d) are arranged.

13. A method for manufacturing an optical communication module according to claim 1, said method comprising the steps of:
- preparing a concave portion on the transparency maintaining unit (10) which accommodates the photoelectric conversion device (20);
- connecting the cylindrical portion (50) to the transparency maintaining unit (10),
- determining a position of the photoelectric conversion device (20), based on the positions of the connection pins (51) protruding from the one side of the transparency maintaining unit (10) to perform a transmission of an optical signal between the one side and the other side through the transparent portion of the transparency maintaining unit (10) and the optical pass portion (31) of the electric conductor (30, 30a - 30d),
- connecting the positionally determined connector (21, 21a - 21d) to the exposed portion of the electric conductor (30, 30a - 30d), and
- making a cover (40) seal the recess portion (12a), to seal the photoelectric conversion device (20) connected to the electric conductor (30, 30a - 30d).

## Patentansprüche

1. Optisches Kommunikationsmodul mit:
(a) einer fotoelektrischen Umwandlungsvorrichtung (20), die eine fotoelektrische Umwandlungseinheit (22) und einen Verbinder (21, 21a - 21d) auf einer Oberfläche der fotoelektrischen Umwandlungsvorrichtung (20) umfasst, wobei die fotoelektrische Umwandlungseinheit (22) eine fotoelektrische Umwandlung eines optischen Signals in ein elektrisches Signal oder eines elektrischen Signals in ein optisches Signal durch Empfangen und Aussenden von Licht durchführt und der Verbinder (21, 21a - 21d) die fotoelektrische Umwandlungsvorrichtung (20) mit einer weiteren Vorrichtung verbindet;
(b) einem elektrischen Leiter (30, 30a - 30d), der mit dem Verbinder (21, 21a - 21d) der fotoelektrischen Umwandlungsvorrichtung (20) verbunden ist und einen Lichtdurchlässigkeitsabschnitt (31) umfasst, der für Licht in Richtung der fotoelektrischen Umwandlungseinheit (22) der verbundenen fotoelektrischen Umwandlungsvorrichtung (20) durchlässig ist;
(c) einer Lichtdurchlässigkeits-Erhaltungseinheit (10), die einen lichtdurchlässigen Abschnitt, der für Licht zwischen einer Seite und einer weiteren, der einen Seite gegenüberliegenden Seite der Lichtdurchlässigkeits-Erhaltungseinheit (10) durchlässig ist, umfasst und die den elektrischen Leiter (30, 30a - 30d) hält, wobei ein Abschnitt, der die fotoelektrische Umwandlungsvorrichtung (20) verbindet, auf der einen Seite freiliegt;
(d) einem Dichtungsmittel (40, 45 46) zum Abdichten der fotoelektrische Umwandlungsvorrichtung (20), die mit dem elektrischen Leiter (30, 30a - 30d) verbunden ist, wobei
(e) die Lichtdurchlässigkeits-Erhaltungseinheit (10) einen Aussparungsabschnitt (12a) umfasst, in dem die fotoelektrische Umwandlungsvorrichtung (20) aufgenommen ist,
(f) das Dichtungsmittel (40, 45, 46) eine Abdeckung (40) umfasst, die den Aussparungsabschnitt (12a) abdichtet,
(g) die fotoelektrische Umwandlungsvorrichtung (20) eine Übertragung eines optischen Signals zwischen der einen Seite und der weiteren Seite durch den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) durchführt, und
(h) ein zylindrischer Abschnitt (50), der an der weiteren Seite der Lichtdurchlässigkeits-Erhaltungseinheit (10) vorragt und innen an eine Kommunikationsleitung zum Durchführen einer optischen Kommunikation angepasst ist, wobei:
(i) der zylindrische Abschnitt (50) einen zylindrischen Körper und mehrere Verbindungsstifte (51), die von dem zylindrischen Körper vorragen, umfasst, und
(j) die Lichtdurchlässigkeits-Erhaltungseinheit (10) mehrere Verbindungslöcher (16) umfasst, durch die sich die Verbindungsstifte (51) zwischen ihrer einen Seite und ihrer weiteren Seite derart erstrecken, dass Spitzenabschnitte davon von der einen Seite der Lichtdurchlässigkeits-Erhaltungseinheit (10) vorragen.

2. Optisches Kommunikationsmodul nach Anspruch 1, das ferner eine oder mehrere elektrische Schaltungskomponenten (61, 62) umfasst, die mit einem Freiliegungsabschnitt des elektrischen Leiters (30, 30a - 30d) verbunden sind, wo der elektrische Leiter (30, 30a - 30d) nach außerhalb des Aussparungsabschnitts (12a) der Lichtdurchlässigkeits-Erhaltungseinheit (10) freiliegt.

3. Optisches Kommunikationsmodul nach Anspruch 2, das ferner einen weiteren der elektrischen Leiter (30, 30a - 30d) umfasst, wobei die fotoelektrische Umwandlungsvorrichtung (20) und die elektrische Schaltungskomponenten (61, 62) durch die elektrischen Leiter (30, 30a - 30d) elektrisch verbunden sind, um so eine elektrische Schaltung für die fotoelektrische Umwandlung zu bilden.

4. Optisches Kommunikationsmodul nach Anspruch 2 oder 3, wobei die elektrische Schaltungskomponente mit dem elektrischen Leiter (30, 30a - 30d) mittels eines Weichlots, das ein Flussmittel enthält, verbunden ist.

5. Optisches Kommunikationsmodul nach einem der Ansprüche 1 bis 4, das ferner eine Linse (15) umfasst, die auf der weiteren Seite der Lichtdurchlässigkeits-Erhaltungseinheit (10) angeordnet ist, wobei:
- die Lichtdurchlässigkeits-Erhaltungseinheit (10) und die Linse (15) einteilig aus einem lichtdurchlässigen Harz gebildet sind, und
- die fotoelektrische Umwandlungsvorrichtung (20) ein optisches Signal zwischen der einen Seite und der weiteren Seite durch die Linse (15), den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) überträgt.

6. Optisches Kommunikationsmodul nach einem der Ansprüche 1 bis 5, das ferner einen zylindrischen Abschnitt (11) umfasst, der auf der weiteren Seite der Lichtdurchlässigkeits-Erhaltungseinheit (10) vorragt und in den eine Kommunikationsleitung zum Durchführen einer optischen Kommunikation passt, wobei:
- der zylindrische Abschnitt (11) einteilig mit der Lichtdurchlässigkeits-Erhaltungseinheit (10) gebildet ist, und
- die fotoelektrische Umwandlungsvorrichtung (20) ein optisches Signal zwischen der einen Seite und der weiteren Seite durch eine innere Fläche des zylindrischen Abschnitts (11), den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) überträgt.

7. Optisches Kommunikationsmodul nach einem der Ansprüche 1 - 5, das ferner einen zylindrisch Abschnitt (80) umfasst, in dem die Durchsichtigkeitseinheit (10) auf einer Seite des zylindrischen Abschnitts und eine Kommunikationsleitung für die optische Kommunikation auf der weiteren Seite des zylindrischen Abschnitts aufgenommen sind, wobei:
- der elektrische Leiter (30, 30a - 30d) plattenförmig ist,
- die Lichtdurchlässigkeits-Erhaltungseinheit (10) den elektrischen Leiter (30, 30a - 30d) hält, dessen Endabschnitt sich nach außen erstreckt,
- eine Oberfläche auf der einen Seite des zylindrischen Abschnitts (80) an einem Abschnitt des elektrischen Leiters (30, 30a - 30d), der sich von der Lichtdurchlässigkeits-Erhaltungseinheit (10) erstreckt, befestigt ist, und
- die fotoelektrische Umwandlungsvorrichtung (20) ein optisches Signal zwischen der einen Seite und der weiteren Seite durch eine innere Fläche des zylindrischen Abschnitts, den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) überträgt.

8. Optisches Kommunikationsmodul nach einem der Ansprüche 1-5, das ferner einen zylindrischen Abschnitt (50) umfasst, der in Kontakt mit der weiteren Seite der Lichtdurchlässigkeits-Erhaltungseinheit (10) befestigt ist und in den eine Kommunikationsleitung für die optische Kommunikation eingepasst ist, wobei:
- Kontaktabschnitte der Lichtdurchlässigkeits-Erhaltungseinheit (10) und des zylindrischen Abschnitts (50) flache Oberflächen sind, und
- die fotoelektrische Umwandlungsvorrichtung (20) die ein optisches Signal zwischen der einen Seite und der weiteren Seite durch eine innere Fläche des zylindrischen Abschnitts (50), den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) überträgt.

9. Optisches Kommunikationsmodul nach einem der Ansprüche 1-8, das ferner eine Positionierungseinheit (13) umfasst, die auf der einen Seite der Lichtdurchlässigkeits-Erhaltungseinheit (10) vorragt und eine Position zum Anordnen der fotoelektrischen Umwandlungsvorrichtung (20) definiert.

10. Optisches Kommunikationsmodul nach einem der Ansprüche 1-8, das ferner eine Positionierungspore umfasst, die die eine Seite und die weitere Seite der Lichtdurchlässigkeits-Erhaltungseinheit (10) durchdringt und eine Position zum Anordnen der fotoelektrischen Umwandlungsvorrichtung (20) definiert, wobei:
- die Lichtdurchlässigkeits-Erhaltungseinheit (10) aus lichtdurchlässigem Harz unter Verwendung einer Form für die eine Seite und für die weitere Seite hergestellt ist, und
- die Positionierungspore mit der weiteren Form für die weitere Seite der Lichtdurchlässigkeits-Erhaltungseinheit (10) gebildet ist.

11. Optisches Kommunikationsmodul nach einem der Ansprüche 1-10, wobei:
- die Lichtdurchlässigkeits-Erhaltungseinheit (10) einen Vorsprung (313) umfasst, der eine Position zum Halten des elektrischen Leiters (30, 30a - 30d) definiert, und
- der elektrische Leiter (30, 30a - 30d) einen Lochabschnitt (332) oder einen konkaven Abschnitt, der an den Vorsprung (313) der Lichtdurchlässigkeits-Erhaltungseinheit (10) angepasst ist, umfasst.

12. Optisches Kommunikationsmodul nach einem der Ansprüche 1-11, das ferner einen Draht (63 - 66) umfasst, der den elektrischen Leiter (30, 30a - 30d) mit einer weiteren Oberfläche der fotoelektrischen Umwandlungsvorrichtung (20), die von der einen Oberfläche verschieden ist, auf der die fotoelektrische Umwandlungseinheit (22) und der Verbinder (21, 21a - 21d) angeordnet sind, elektrisch verbindet.

13. Verfahren zur Herstellung eines optischen Kommunikationsmoduls nach Anspruch 1, wobei das Verfahren die Schritte umfasst:
- Vorbereiten eines konkaven Abschnitts auf der Lichtdurchlässigkeits-Erhaltungseinheit (10), in der die fotoelektrische Umwandlungsvorrichtung (20) aufgenommen ist;
- Verbinden des zylindrischen Abschnitts (50) mit der Lichtdurchlässigkeits-Erhaltungseinheit (10),
- Bestimmen einer Position der fotoelektrischen Umwandlungsvorrichtung (20) auf der Grundlage der Positionen der Verbindungsstifte (51), die von der einen Seite der Lichtdurchlässigkeits-Erhaltungseinheit (10) vorragen, um ein optisches Signal zwischen der einen Seite und der weiteren Seite durch den lichtdurchlässigen Abschnitt der Lichtdurchlässigkeits-Erhaltungseinheit (10) und den Lichtdurchlässigkeitsabschnitt (31) des elektrischen Leiters (30, 30a - 30d) zu übertragen,
- Verbinden der positionsbestimmten Verbinder (21, 21a - 21d) mit dem freiliegenden Abschnitt des elektrischen Leiters (30, 30a - 30d), und
- Abdichten des Aussparungsabschnitts (12a) durch eine Abdeckung (40), um die fotoelektrische Umwandlungsvorrichtung (20), die mit dem elektrischen Leiter (30, 30a - 30d) verbunden ist, abzudichten.

## Revendications

1. Module de communication optique, comprenant :
(a) un dispositif de conversion photoélectrique (20) qui est pourvu d'une unité de conversion photoélectrique (22) et d'un connecteur (21, 21a à 21d) sur une surface du dispositif de conversion photoélectrique (20), dans lequel l'unité de conversion photoélectrique (22) réalise une conversion photoélectrique d'un signal optique en un signal électrique ou d'un signal électrique en un signal optique avec réception ou émission de lumière, et le connecteur (21, 21a à 21d) connecte le dispositif de conversion photoélectrique (20) à un autre dispositif ;
(b) un conducteur électrique (30, 30a à 30d) qui est connecté au connecteur (21, 21a à 21d) du dispositif de conversion photoélectrique (20) et est pourvu d'une portion de passage optique (31) qui fait passer de la lumière vers l'unité de conversion photoélectrique (22) du dispositif de conversion photoélectrique (20) connecté ;
(c) une unité de maintien de transparence (10) qui comprend une portion transparente faisant passer de la lumière entre un côté et un autre côté, opposé au premier côté, de l'unité de maintien de transparence (10) et qui tient le conducteur électrique (30, 30a à 30d), dans lequel une portion connectant le dispositif de conversion photoélectrique (20) est exposée au niveau du premier côté ;
(d) un moyen d'obturation (40, 45, 46) destiné à obturer le dispositif de conversion photoélectrique (20) connecté au conducteur électrique (30, 30a à 30d), dans lequel
(e) l'unité de maintien de transparence (10) est pourvue d'une portion d'évidement (12a) qui accueille le dispositif de conversion photoélectrique (20),
(f) le moyen d'obturation (40, 45, 46) est pourvu d'un couvercle (40) qui obture la portion d'évidement (12a),
(g) le dispositif de conversion photoélectrique (20) réalise une transmission d'un signal optique entre le premier côté et l'autre côté à travers la portion transparente de l'unité de maintien de transparence (10) et la portion de passage optique (31) du conducteur électrique (30, 30a à 30d), et
(h) une portion cylindrique (50) qui dépasse au niveau de l'autre côté de l'unité de maintien de transparence (10) et se conforme intérieurement à une ligne de communication permettant de réaliser une communication optique, dans lequel :
(i) la portion cylindrique (50) comprend un corps cylindrique et plusieurs broches de connexion (51) dépassant du corps cylindrique, et
(j) l'unité de maintien de transparence (10) comprend une pluralité de trous de connexion (16) à travers lesquels les broches de connexion (51) s'étendent entre son premier côté et son autre côté de manière à ce que des portions de bout de celles-ci dépassent du premier côté de l'unité de maintien de transparence (10).

2. Module de communication optique selon la revendication 1, comprenant en outre un ou plusieurs composants de circuit électrique (61, 62) qui sont connectés à une portion d'exposition du conducteur électrique (30, 30a à 30d) où le conducteur électrique (30, 30a à 30d) est exposé à l'extérieur de la portion d'évidement (12a) de l'unité de maintien de transparence (10).

3. Module de communication optique selon la revendication 2, comprenant en outre un autre des conducteurs électriques (30, 30a à 30d), dans lequel le dispositif de conversion photoélectrique (20) et les composants de circuit électrique (61, 62) sont électriquement connectés à travers les conducteurs électriques (30, 30a à 30d), pour configurer un circuit électrique pour la conversion photoélectrique.

4. Module de communication optique selon la revendication 2 ou 3, dans lequel le composant de circuit électrique est connecté au conducteur électrique (30, 30a à 30d) avec une brasure tendre incluant un flux.

5. Module de communication optique selon l'une quelconque des revendications 1 à 4, comprenant en outre une lentille (15) agencée au niveau de l'autre côté de l'unité de maintien de transparence (10), dans lequel :
- l'unité de maintien de transparence (10) et la lentille (15) sont formées solidairement avec une résine transparente, et
- le dispositif de conversion photoélectrique (20) réalise une transmission d'un signal optique entre le premier côté et l'autre côté à travers la lentille (15), la portion transparente de l'unité de maintien de transparence (10) et la portion de passage optique (31) du conducteur électrique (30, 30a à 30d).

6. Module de communication optique selon l'une quelconque des revendications 1 à 5, comprenant en outre une portion cylindrique (11) qui dépasse de l'autre côté de l'unité de maintien de transparence (10) et se conforme intérieurement à une ligne de communication permettant de réaliser une communication optique, dans lequel :
- la portion cylindrique (11) est formée solidairement conjointement avec l'unité de maintien de transparence (10), et
- le dispositif de conversion photoélectrique (20) réalise la transmission d'un signal optique entre le premier côté et l'autre côté à travers une zone interne de la portion cylindrique (11), la portion transparente de l'unité de maintien de transparence (10) et la portion de passage optique (31) du conducteur électrique (30, 30a à 30d).

7. Module de communication optique selon l'une quelconque des revendications 1 à 5, comprenant en outre une portion cylindrique (80) qui accueille l'unité de transparence (10) au niveau d'un côté de la portion cylindrique et une ligne de communication pour la communication optique au niveau de l'autre côté de la portion cylindrique, dans lequel :
- le conducteur électrique (30, 30a à 30d) est créé sous forme de plaque,
- l'unité de maintien de transparence (10) tient le conducteur électrique (30, 30a à 30d) dont la portion d'extrémité s'étend vers l'extérieur,
- une surface au niveau du premier côté de la portion cylindrique (80) est fixée à une portion du conducteur électrique (30, 30a à 30d) s'étendant depuis l'unité de maintien de transparence (10), et
- le dispositif de conversion photoélectrique (20) réalise la transmission d'un signal optique entre le premier côté et l'autre côté à travers une zone interne de la portion cylindrique, la portion transparente de l'unité de maintien de transparence (10) et la portion de passage optique (31) du conducteur électrique (30, 30a à 30d).

8. Module de communication optique selon l'une quelconque des revendications 1 à 5, comprenant en outre une portion cylindrique (50) qui est fixée en contact avec l'autre côté de l'unité de maintien de transparence (10) et se conforme intérieurement à une ligne de communication pour la communication optique, dans lequel :
- des portions de contact de l'unité de maintien de transparence (10) et de la portion cylindrique (50) sont des surfaces plates, et
- le dispositif de conversion photoélectrique (20) réalise la transmission d'un signal optique entre le premier côté et l'autre côté à travers une zone interne de la portion cylindrique (50), la portion transparente de l'unité de maintien de transparence (10) et la portion de passage optique (31) du conducteur électrique (30, 30a à 30d).

9. Module de communication optique selon l'une quelconque des revendications 1 à 8, comprenant en outre une unité de positionnement (13) qui dépasse du premier côté de l'unité de maintien de transparence (10) et définit une position permettant d'agencer le dispositif de conversion photoélectrique (20).

10. Module de communication optique selon l'une quelconque des revendications 1 à 8, comprenant en outre un pore de positionnement qui pénètre le premier côté et l'autre côté de l'unité de maintien de transparence (10) et définit une position pour agencer le dispositif de conversion photoélectrique (20), dans lequel :
- l'unité de maintien de transparence (10) est constituée d'une résine transparente avec emploi d'un moule pour le premier côté et d'un autre moule pour l'autre côté, et
- le pore de positionnement est formé avec l'autre moule pour l'autre côté de l'unité de maintien de transparence (10).

11. Module de communication optique selon l'une quelconque des revendications 1 à 10, dans lequel :
- l'unité de maintien de transparence (10) comprend une saillie (313) qui définit une position permettant de tenir le conducteur électrique (30, 30a à 30d), et
- le conducteur électrique (30, 30a à 30d) comprend une portion de trou (332) ou une portion concave qui se conforme à la saillie (313) de l'unité de maintien de transparence (10).

12. Module de communication optique selon l'une quelconque des revendications 1 à 11, comprenant en outre un fil (63 à 66) qui connecte électriquement le conducteur électrique (30, 30a à 30d) à une autre surface du dispositif de conversion photoélectrique (20) différente de la première surface sur laquelle sont agencés l'unité de conversion photoélectrique (22) et le connecteur (21, 21a à 21d).

13. Procédé de fabrication d'un module de communication optique selon la revendication 1, le procédé comprenant les étapes suivantes :
- la préparation d'une portion concave sur l'unité de maintien de transparence (10) qui accueille le dispositif de conversion photoélectrique (20) ;
- la connexion de la portion cylindrique (50) à l'unité de maintien de transparence (10),
- la détermination d'une position du dispositif de conversion photoélectrique (20), d'après les positions des broches de connexion (51) dépassant du premier côté de l'unité de maintien de transparence (10) pour réaliser une transmission d'un signal optique entre le premier côté et l'autre côté à travers la portion transparente de l'unité de maintien de transparence (10) et la portion de passage optique (31) du conducteur électrique (30, 30a à 30d),
- la connexion du connecteur (21, 21a à 21d) de position déterminée à la portion exposée du conducteur électrique (30, 30a à 30d), et
- le fait d'amener un couvercle (40) à obturer la portion d'évidement (12a), pour obturer le dispositif de conversion photoélectrique (20) connecté au conducteur électrique (30, 30a à 30d).
